(19) Europäisches Patentamt
European Patent Office
Office européen des brevets

(11) **EP 2 191 444 B1**

(12) **EUROPÄISCHE PATENTSCHRIFT**

(45) Veröffentlichungstag und Bekanntmachung des Hinweises auf die Patenterteilung:
**05.07.2017 Patentblatt 2017/27**

(51) Int Cl.:
**G06T 11/00** *(2006.01)*  **G01R 19/08** *(2006.01)*

(21) Anmeldenummer: **08801207.5**

(22) Anmeldetag: **20.08.2008**

(86) Internationale Anmeldenummer:
**PCT/DE2008/001384**

(87) Internationale Veröffentlichungsnummer:
**WO 2009/036726 (26.03.2009 Gazette 2009/13)**

(54) **VERFAHREN ZUR TOMOGRAPHISCHEN REKONSTRUKTION EINER MESSGRÖSSE DURCH GEZIELTE BESTIMMUNG DER MESSPUNKTE**

METHOD FOR TOMOGRAPHIC RECONSTRUCTION OF A MEASUREMENT VARIABLE BY SPECIFIC DETERMINATION OF THE MEASUREMENT POINTS

PROCÉDÉ DE RECONSTRUCTION TOMOGRAPHIQUE D'UNE GRANDEUR DE MESURE PAR DÉTERMINATION DIRIGÉE DES POINTS DE MESURE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **17.09.2007 DE 102007044257**

(43) Veröffentlichungstag der Anmeldung:
**02.06.2010 Patentblatt 2010/22**

(73) Patentinhaber:
• **Forschungszentrum Jülich GmbH**
**52425 Jülich (DE)**
• **Fachhochschule Aachen**
**52428 Jülich (DE)**

(72) Erfinder:
• **STEFFEN, Bernhard**
**52382 Niederzier (DE)**
• **LUSTFELD, Hans**
**52428 Jülich (DE)**
• **HIRSCHFELD, Julian**
**80807 München (DE)**
• **REISSEL, Martin**
**52457 Aldenhoven (DE)**
• **SCHMIDT, Uli**
**52070 Aachen (DE)**

(56) Entgegenhaltungen:
**EP-A- 0 944 025    DE-A1-102006 035 741**

• **BRANKOV J G ET AL: "Tomographic Image Reconstruction Based on a Content-Adaptive Mesh Model" 1. Februar 2004 (2004-02-01), IEEE TRANSACTIONS ON MEDICAL IMAGING, IEEE SERVICE CENTER, PISCATAWAY, NJ, US, PAGE(S) 202 - 212 , XP011106355 ISSN: 0278-0062 Seite 207, rechte Spalte, letzter Absatz - Seite 208, linke Spalte**
• **KARL-HEINZ HAUER ET AL: "Magnetic tomography for fuel cells-current status and problems" 1. Juni 2007 (2007-06-01), JOURNAL OF PHYSICS: CONFERENCE SERIES, INSTITUTE OF PHYSICS PUBLISHING, BRISTOL, GB, PAGE(S) 12008 , XP020125033 ISSN: 1742-6596 Seite 13, Absatz 3 - Seite 15**
• **LI ET AL: "High-quality rendering with depth cueing of volumetric data using Monte Carlo integration" COMPUTERS IN BIOLOGY AND MEDICINE, NEW YORK, NY, US, Bd. 36, Nr. 9, 1. September 2006 (2006-09-01), Seiten 1014-1025, XP005615560 ISSN: 0010-4825**

EP 2 191 444 B1

**Beschreibung**

Die Erfindung betrifft ein Verfahren zur tomographischen Rekonstruktion einer Messgröße aus einer der Messung zugänglichen Hilfsgröße, ein Verfahren zur Bestimmung optimaler Messorte für die Hilfsgröße sowie Vorrichtungen zur Durchführung der Verfahren.

Stand der Technik

In der Medizin, in der Sicherheitstechnik, bei der Exploration von Böden und bei der Untersuchung in Betrieb befindlicher experimenteller Aufbauten ist häufig die Verteilung einer Messgröße im Inneren einer Probe gesucht, die einer direkten Messung nur sehr ungenau, mit hohem Aufwand oder unter Inkaufnahme eines zerstörerischen Eingriffs in die Probe zugänglich ist. In derartigen Fällen wird eine Hilfsgröße gemessen, die mit der Verteilung der Messgröße in einem physikalischen Zusammenhang steht und die einer Messung besser zugänglich ist. Aus den Werten der Hilfsgröße wird anschließend durch tomographische Rekonstruktion auf die Verteilung der Messgröße im Inneren der Probe geschlossen. Beispielsweise ist in der Computertomographie die Dichteverteilung der Materie im Körper die Messgröße, und die Absorption von durch den Körper geleiteter Röntgenstrahlung wird als Hilfsgröße verwendet.
Tomographische Rekonstruktionen erfordern Messungen der Hilfsgröße an vielen Orten. Dies erfordert entweder eine große Anzahl an Detektoren, um Werte der Hilfsgröße an vielen Orten simultan zu messen, oder viel Messzeit, um mit einem oder mehreren beweglichen Detektoren die Werte an vielen Orten nacheinander zu messen.

Aufgabe und Lösung

Es ist daher die Aufgabe der Erfindung, die tomographische Rekonstruktion einer Messgröße im Inneren einer Probe mit einem geringeren Aufwand für die Aufnahme von Werten der Hilfsgröße durchführbar zu machen als nach dem Stand der Technik, wobei die Auflösung, mit der die Messgröße bestimmt werden kann, höchstens geringfügig abnehmen soll.
Diese Aufgabe wird erfindungsgemäß gelöst durch Verfahren gemäß Haupt- und Nebenansprüchen sowie durch Vorrichtungen zur Durchführung des Verfahrens gemäß weiteren Nebenansprüchen. Weitere vorteilhafte Ausgestaltungen ergeben sich jeweils aus den darauf rückbezogenen Unteransprüchen.

Gegenstand der Erfindung

Im Rahmen der Erfindung wurde ein Verfahren zur tomographischen Rekonstruktion der Verteilung einer Messgröße innerhalb einer Probe aus Werten einer Hilfsgröße gefunden.
Die Werte der Hilfsgröße können außerhalb der Probe gemessen werden. Sie können aber ausdrücklich auch innerhalb der Probe gemessen werden, beispielsweise, indem eine entsprechende Sonde in die Probe eingebracht wird.
Erfindungsgemäß werden bei der Ermittlung der Verteilung der Messgröße die Werte der Hilfsgröße an Hand eines Relevanzmaßes gewichtet.
Unter einem Relevanzmaß im Sinne dieser Erfindung ist jede Funktion zu verstehen, die einem Ort einen Zahlenwert zuordnet, welcher ein Maß für die Aussagekraft eines an diesem Ort gemessenen Wertes der Hilfsgröße hinsichtlich der Verteilung der Messgröße ist, und die zugleich nicht allein ein Maß für den Abstand des Orts von einem Bezugspunkt der Probe ist. Dieser Bezugspunkt kann beispielsweise der Mittelpunkt der Probe sein. Die konkrete Ausgestaltung des Relevanzmaßes ist davon abhängig, welche Art von Information im konkreten Anwendungsfall nachgefragt wird.
Ein Ort im Sinne dieser Erfindung befindet sich in einem Bezugssystem, in dem die Probe ruht. Somit ist es etwa für eine Messung der Hilfsgröße an zwei verschiedenen Orten unerheblich, ob der für diese Messung verwendete Detektor bewegt (beziehungsweise am Ort der zweiten Messung physisch ein zweites Mal vorhanden) ist oder ob die Probe bewegt, insbesondere translatiert oder gedreht, wird.
Ein Relevanzmaß muss nicht im gesamten Raum erklärt sein. Es kann beispielsweise nur auf einer Menge von Orten erklärt sein, die einer durch den Anwendungsfall vorgegebenen Zwangsbedingung genügen. Das Relevanzmaß kann beispielsweise nur auf der Menge derjenigen Orte erklärt sein, die überhaupt technisch oder finanziell für eine Messung der Hilfsgröße zugänglich sind, so dass relevante Orte sinnvollerweise nur aus dieser Menge ausgewählt werden können.
Ein Relevanzmaß muss nicht notwendigerweise durch eine analytische Formel beschreibbar sein und auch nicht stetig sein. Beispielsweise können die Werte des Relevanzmaßes ausschließlich durch numerische Simulation an Hand eines Modells der Probe bestimmbar sein. Solche numerischen Simulationen kann der Fachmann auch zu Hilfe nehmen, um für einen konkreten Anwendungsfall ein Relevanzmaß zu ermitteln. Soll beispielsweise die Probe auf das Vorliegen bestimmter Defekte untersucht werden, so kann er in einem ungestörten Modell der Probe diese Defekte einbringen, ihre Auswirkung auf die Werte der Hilfsgröße studieren und das Relevanzmaß so ausgestalten, dass es die Orte besonders hoch bewertet, an denen Messungen für eine zuverlässige Erkennung der Defekte besonders wichtig sind.

Es wurde erkannt, dass durch die erfindungsgemäße Gewichtung mit dem Relevanzmaß die relative Genauigkeit verbessert werden kann, mit der sich die Verteilung der Messgröße rekonstruieren lässt. Tomographische Rekonstruktion ist grundsätzlich die Lösung eines inversen Problems. Sie läuft in linearer Näherung auf die Lösung eines überbestimmten linearen Gleichungssystems hinaus. Dabei können kleine Änderungen in den gemessenen Werten der Hilfsgröße große Änderungen in der rekonstruierten Verteilung der Messgröße zur Folge haben. Die Gewichtung bewirkt, dass bei der widersprüchlichen Entscheidung, in welche Richtung sich die Lösung des überbestimmten Gleichungssystems entwickelt, die im Hinblick auf die wahre Verteilung der Messgröße glaubwürdigeren Stimmen lauter zu Wort kommen.

Beispielsweise können Messwerte der Hilfsgröße von Orten, an denen sie nur ungenau oder nur schwierig gemessen werden können, mit dem Wert Null gewichtet werden und somit bei der tomographischen Rekonstruktion ganz unberücksichtigt bleiben.

Zugleich kann auch der Aufwand für die Datenaufnahme verringert werden. Ist durch das Relevanzmaß vorab bekannt, an welchen Orten Messungen im Hinblick auf die Verteilung der Messgröße besonders lohnend sind, können Messungen vorteilhaft auf diese Orte eingegrenzt werden. Werden die Werte der Hilfsgröße mit mehreren ortsfesten Detektoren gemessen, sind für die gleiche Qualität der Rekonstruktion weniger Detektoren erforderlich. Werden die Werte der Hilfsgröße mit einem oder mehreren beweglichen Detektoren gemessen, die die Messorte jeweils anfahren, ist für die gleiche Qualität der Rekonstruktion eine geringere Messzeit erforderlich. Dadurch können dynamische Prozesse in der Probe auf einer kürzeren Zeitskala studiert werden.

Es kann auch in beliebigen Abstufungen sowohl die Genauigkeit verbessert als auch der Aufwand für die Datenaufnahme verringert werden. Diese Ziele schließen sich nicht gegenseitig aus: Überraschenderweise wurde festgestellt, dass gerade eine Reduktion der bei der tomographischen Rekonstruktion berücksichtigten Datenmenge eine Verbesserung der Genauigkeit bewirken kann.

Als Relevanzmaß kann beispielsweise die optimale Verteilung von Messorten verwendet werden, die mit einem Optimierungsverfahren bestimmt wurde, oder diese optimale Verteilung kann zumindest in ein solches Relevanzmaß eingehen. Eine solche Verteilung kann beispielsweise als Dichte beschrieben werden. Die Erfindung bezieht sich auch auf ein Verfahren zur Bestimmung der optimalen Verteilung von Messorten, an denen zwecks tomographischer Rekonstruktion einer Messgröße innerhalb der Probe eine der Messung zugängliche Hilfsgröße zu messen ist. Bei diesem Verfahren wird die Verteilung von Messorten auf den Extremwert eines Funktionals hin optimiert, welches eine Faltung dieser Verteilung von Orten mit einer Funktion f(S) des Operators S enthält, der jeder möglichen Verteilung der Messgröße eine Verteilung der Hilfsgröße zuordnet. Die Erfindung bezieht sich auch auf ein Verfahren zur tomographischen Rekonstruktion der Verteilung einer Messgröße innerhalb einer Probe aus Werten einer Hilfsgröße, bei dem die solchermaßen optimierte Verteilung von Messorten als Relevanzmaß verwendet wird.

Die Funktion f(S) hängt implizit über S immer von einem Ort **x** ab, weil S ein Operator ist, der auf Orte **x** wirkt. f(S) kann aber auch zusätzlich eine explizite Ortsabhängigkeit f(S,**x**) enthalten. f(S) kann insbesondere die Multiplikation des zu S adjungierten Operators $S^+$ mit S beinhalten. Allgemein ist es vorteilhaft, wenn f(S) die Multiplikation eines Operators mit dem zu ihm adjungierten Operator beinhaltet.

Der Operator S verkörpert das zu lösende tomographische Problem. In ihm stecken neben dem physikalischen Zusammenhang zwischen Messgröße und Hilfsgröße auch die Dimensionalitäten der Räume, in denen die Verteilung der Hilfsgröße gemessen beziehungsweise die Verteilung der Messgröße gesucht wird.

Die Funktion f(S) kann aber auch von einem aus dem Operator S abgeleiteten Operator abhängen. Ist beispielsweise S ein linearer Operator, so lässt er sich als Matrix schreiben, die sich im Wege der Singularwertzerlegung als $U \cdot W \cdot V^T$ ausdrücken lässt. Dabei kann die Matrix diskret oder auch kontinuierlich indiziert sein. In der Singularwertzerlegung sind U eine orthogonale Matrix, W eine Diagonalmatrix mit den Singularwerten und V eine unitäre Matrix. Auch eine Funktion f(U) des Operators U ist daher eine Funktion f(S): Da U sich aus S errechnen lässt, lässt sich f(U(S)) ebenfalls rechnerisch in eine Form f(S) bringen.

Da sowohl $V^T$ als auch W quadratisch sind, verkörpert U allein die Information über die Abweichung von S von der quadratischen Gestalt. Somit steckt auch die Information, inwieweit S prinzipiell lokal invertierbar (und somit das tomographische Problem lösbar) ist, allein in U, sofern die Singularwerte von S ungleich Null sind.

Die Verteilung von Messorten kann beispielsweise in einer Funktion verkörpert sein, die in ihrem Definitionsbereich jedem Ort eine lokale Dichte von Messorten pro Einheit Volumen, Fläche oder Länge entlang einer Kurve zuordnet. Der Begriff der Verteilung von Messorten ist jedoch nicht auf solche Funktionen eingeschränkt und insbesondere nicht auf solche, die kontinuierlich mit dem Ort variieren. Er umfasst jede Zuordnung, die zu einem Ort in ihrem Definitionsbereich angibt, ob oder auch mit welcher Priorität zur Erzielung einer optimalen tomographischen Rekonstruktion der Messgröße die Hilfsgröße an genau diesem Ort zu messen ist.

Unter der Faltung der Verteilung von Messorten mit der Funktion f(S) werden jedes Integral und jede Summe über mehr als einen Ort **x** verstanden, die eine Verknüpfung der Verteilung am Ort **x** mit dieser Funktion f(S) enthält. Dabei ist die Ortsabhängigkeit von f(S), die zumindest implizit über S immer gegeben ist, zu berücksichtigen. Dieser Begriff der Faltung erstreckt sich ausdrücklich auch auf Funktionen f(S), die Matrizen mit diskreten oder kontinuierlichen Indizes sind.

Es wurde erkannt, dass durch dieses erfindungsgemäße Optimierungsverfahren die sinnvolle Anordnung der Messorte, die bislang von Erfahrungswissen und experimentellem Geschick des Fachmanns mitbestimmt wurde, erstmals einer systematischen technischen Optimierung auf ein definiertes Qualitätsziel hin zugänglich gemacht wird. Dabei geht dieses definierte Ziel im Wesentlichen in die konkrete Abhängigkeit des Funktionals von der Faltung ein. Somit wird das Funktional durch die konkret gestellte Optimierungsaufgabe maßgeblich bestimmt.

Das definierte Ziel kann zum Teil auch Einfluss auf die Wahl des Operators haben, der in die Funktion f(S) eingeht. Wird im obigen linearen Beispiel der Operator S verwendet, so enthält die Faltung ein Maß dafür, wie stark sich Änderungen der Messgröße innerhalb der Probe auf gemessene Werte der Hilfsgröße auswirken. Wird der Operator U verwendet, so enthält die Faltung ein Maß dafür, wie viel Information ein gemessener Wert der Hilfsgröße über die gesamte Verteilung der Messgröße enthält.

Das Funktional erhält ganz allgemein die Verteilung von Messorten als Argument und liefert einen skalaren Wert W. Je nach Ausgestaltung des Funktionals kann dieser Wert ein Maß für eine gewünschte vorteilhafte Eigenschaft oder eine Verknüpfung derartiger Eigenschaften sein, wie beispielsweise für die bei der tomographischen Rekonstruktion erzielbare Genauigkeit.

Die Erfindung bezieht sich gleichermaßen auf ein Verfahren zur Bestimmung der optimalen Verteilung von Messorten, an denen zwecks tomographischer Rekonstruktion einer Messgröße innerhalb der Probe eine der Messung zugängliche Hilfsgröße zu messen ist, wobei die Verteilung von Messorten auf den Extremwert eines Funktionals hin optimiert wird, welches mindestens einen Singularwert eines Operators enthält, der ein Produkt aus einer Potenz der Verteilung von Messorten mit dem Operator S beinhaltet, welcher jeder möglichen Verteilung der Messgröße eine Verteilung der Hilfsgröße zuordnet. Die Potenz muss nicht ganzzahlig sein, sondern kann auch rational oder reellwertig sein. Insbesondere kann das Produkt die Quadratwurzel der Verteilung von Messorten beinhalten.

Der technische Zusammenhang zu einem Funktional, welches eine Faltung dieser Verteilung von Orten mit einer Funktion f(S) des Operators S enthält, der jeder möglichen Verteilung der Messgröße eine Verteilung der Hilfsgröße zuordnet, wird für den Fall eines linearen Operators im Speziellen Beschreibungsteil hergeleitet.

Die mit einem der erfindungsgemäßen Verfahren bestimmte Verteilung von Messorten korreliert direkt damit, wie relevant eine Messung an jedem Ort x, an dem diese Verteilung erklärt ist, für die durch das Funktional definierte Qualität der tomographischen Rekonstruktion ist. Dabei ist das Funktional in der Regel durch das in der konkreten Aufgabenstellung vorgegebene Optimierungsziel bestimmt. Die Verteilung ist somit nicht nur als Vorschrift für die zu realisierende Dichte von Messpunkten im Raum zu interpretieren, sondern auch als ein Relevanzmaß für Orte **x** bezüglich desjenigen Funktionals, bei dessen Optimierung sie erhalten wurde.

In einer besonders vorteilhaften Ausgestaltung der Erfindung wird das Optimierungsverfahren iterativ durchgeführt, wobei die Verteilung von Messorten beim Übergang von der Iteration n-1 auf die Iteration n um ein punktweises Produkt der Iteration n-1 dieser Verteilung mit einer zu dieser Verteilung orthogonalen, insbesondere orthonormalen, Korrekturfunktion geändert wird. Das mit dem Optimierungsverfahren verfolgte Ziel ist erfindungsgemäß durch ein Funktional definiert, das die Verteilung von Messorten enthält. Da nun beim Übergang von der Iteration n-1 auf die Iteration n die Iteration n-1 der Verteilung als bekannt vorausgesetzt wird, wird durch Einsetzen einer Faltung der Iteration n-1 mit der Korrekturfunktion in das Funktional die Bestimmung der Iteration n auf die Bestimmung der Korrekturfunktion zurückgeführt. Dabei kann insbesondere das für die Optimierung verwendete Funktional von einer Iteration zur nächsten variieren. Dadurch kann ein flexibler Kompromiss zwischen konfligierenden Optimierungszielen, wie etwa absoluter und relativer Genauigkeit, aufgefunden werden.

Beispielsweise können nachteilige Nebenwirkungen, die durch eine Iteration bewirkt wurden, durch Anpassung des Funktionals bei nachfolgenden Iterationen berücksichtigt und somit behoben werden.

Als Startwert für das iterativ durchgeführte Verfahren kommt beispielsweise eine im Raum homogene oder auch eine auf Grund von a priori-Information über die Verteilung der Messgröße festgesetzte Verteilung von Messorten in Betracht.

Sowohl bei der tomographischen Rekonstruktion als auch bei der Bestimmung der optimalen Verteilung von Messorten wird vorteilhaft der Zusammenhang zwischen der Verteilung der Messgröße innerhalb der Probe und den Werten der Hilfsgröße um einen Arbeitspunkt im Raum der möglichen Verteilungen der Messgröße linearisiert. Dann sind die Verteilung der Messgröße und die Werte der Hilfsgröße auch dann durch einen linearen Operator S verknüpft, wenn der physikalische Zusammenhang zwischen diesen Größen nichtlinear ist. Für solche Operatoren liefert die Singularwertzerlegung von S eine Aussage darüber, wie stark sich eine Änderung in der Verteilung der Messgröße auf die Werte der Hilfsgröße auswirkt. Die Hilfsgröße lässt sich in der Regel nur mit begrenzter Genauigkeit messen. Die Art und Stärke der Kopplung zwischen Messgröße und Hilfsgröße, die in der Singularwertzerlegung von S stecken, verknüpfen durch Fehlerfortpflanzung diese Messgenauigkeit mit der letztendlich erreichbaren Genauigkeit der tomographischen Rekonstruktion. Ist in einer solchen linearen Näherung der Zusammenhang zwischen Änderungen dH von H und dm von m gegeben durch dH=S·dm, so ist die bei gegebener Messgenauigkeit δH der Hilfsgröße erzielbare Genauigkeit δm der Messgröße nach der tomographischen Rekonstruktion gegeben durch

$$|\delta m| \leq \frac{1}{\sqrt{\lambda_u}} |\delta H|,$$

worin $\lambda_u$ der kleinste Eigenwert von S⁺S ist, zu dem Eigenvektoren im Raum der Verteilungen der Hilfsgröße berücksichtigt werden. Zur Optimierung der Verteilung von Messorten auf einen möglichst geringen absoluten Fehler der Rekonstruktion hin enthält daher das Funktional vorteilhaft ein Maß für den kleinsten Eigenwert des Operators S⁺S, und damit ein Maß für den kleinsten Singularwert des Operators S, der eine Verteilung der Messgröße auf eine Verteilung der Hilfsgröße abbildet, oder für die Veränderung dieses Werts.

Welche Eigenvektoren und damit welche Eigenwerte berücksichtigt werden, richtet sich nach der gewünschten Darstellungsgenauigkeit. Die zu rekonstruierende Struktur muss in dem durch die berücksichtigten Eigenvektoren aufgespannten Raum enthalten sein. Je kleiner die zu den berücksichtigten Eigenvektoren gehörenden Eigenwerte, desto größer ist jedoch die Empfindlichkeit der tomographischen Rekonstruktion gegen Rauschen und sonstige Störungen. Insofern ist hier bezogen auf den konkreten Anwendungsfall immer ein Kompromiss zu schließen.

Der relative Fehler ist gegeben durch

$$\frac{|\delta m|}{|dm|} \leq \sqrt{\frac{\lambda_o}{\lambda_u}} \cdot \frac{|\delta H|}{|dH|},$$

worin $\lambda_o$ der größte Eigenwert von S⁺S ist, zu dem Eigenvektoren im Raum der Verteilungen der Hilfsgröße berücksichtigt werden. Der relative Fehler hängt somit vom Verhältnis zwischen dem größten und dem kleinsten Eigenwert ab. Zur Optimierung der Verteilung von Messorten auf einen möglichst geringen relativen Fehler der Rekonstruktion hin enthält daher das Funktional vorteilhaft ein Maß für das Verhältnis zwischen dem größten und dem kleinsten Singularwert des Operators, der eine Verteilung der Messgröße auf eine Verteilung der Hilfsgröße abbildet, oder für die Änderung dieses Verhältnisses.

Die Verteilung der Hilfsgröße setzt sich zusammen aus der in dem Optimierungsverfahren gesuchten Verteilung von Messorten und den Messwerten, die die Hilfsgröße an diesen Messorten annimmt.

Ein möglichst geringer absoluter Fehler und ein möglichst geringer relativer Fehler können konfligierende Optimierungsziele für die Bestimmung der Verteilung der Messorte sein.

Die lineare Näherung liefert darüber hinaus auch Aussagen, inwieweit eine tomographische Rekonstruktion überhaupt möglich ist. Hat der Operator S⁺S (worin S⁺ der zu S adjungierte Operator ist) einen Nullraum, so gibt es Verteilungen der Messgröße, die aus keiner wie auch immer gearteten Verteilung der Werte der Hilfsgröße bestimmt werden können. Gleiches gilt, wenn zwecks Verbesserung der absoluten oder der relativen Genauigkeit der Rekonstruktion Eigenvektoren zu bestimmten Eigenwerten von SS⁺ nicht berücksichtigt werden. Die Ortsauflösung, mit der die Verteilung der Messgröße rekonstruiert werden kann, hängt von der Zahl N der berücksichtigten Eigenvektoren von SS⁺ ab:

$$r_s \propto \left( \frac{|W|}{N} \right)^{1/d_w},$$

worin $d_w$ die Dimension des Bereiches ist, in dem die Verteilung der Messgröße gesucht wird (Linie: 1, Fläche: 2, Volumen: 3). |W| ist dementsprechend die Länge, der Flächeninhalt oder der Rauminhalt dieses Bereichs. Mit zunehmendem N wird der Nenner größer, so dass feinere Strukturen auflösbar werden. Je größer $d_w$, desto mehr Eigenvektoren sind für die gleiche Ortsauflösung erforderlich.

Vorteilhaft wird eine a priori erwartete Verteilung der Messgröße als Arbeitspunkt gewählt. Ist die Probe beispielsweise ein technisches Gerät, wie etwa eine Brennstoffzelle, so kann der Arbeitspunkt die Verteilung der Messgröße bei störungsfreiem Betrieb sein.

In einer weiteren vorteilhaften Ausgestaltung der Erfindung wird der Extremwert des Funktionals unter der Nebenbedingung bestimmt, dass eine Faltung der Verteilung der Messorte mit einer ortsabhängigen Gewichtsfunktion einen vorgegebenen Wert annimmt. Durch eine derartige Nebenbedingung können über die Ausgestaltung der Gewichtsfunktion Raumgebiete, in denen Messungen zwar nicht verboten, aber möglichst gemieden werden sollen, bei der Optimierung berücksichtigt werden. Dies ist beispielsweise von Vorteil, wenn der Aufwand für Messungen in diesen Raumgebieten besonders groß ist. Analog können über eine derartige Nebenbedingung durch Wahl einer geeigneten Gewichtsfunktion aber auch Raumgebiete, in denen Messungen besonders leicht möglich sind, bevorzugt werden.

In einer weiteren vorteilhaften Ausgestaltung der Erfindung wird der Extremwert des Funktionals unter der Nebenbedingung bestimmt, dass eine Faltung der Verteilung der Messorte mit sich selbst einen vorgegebenen Wert annimmt. Unter einer solchen Faltung der Verteilung der Messorte mit sich selbst wird insbesondere eine ganzzahlige oder reellwertige Potenz dieser Verteilung verstanden. Über den vorgegebenen Wert lässt sich steuern, ob eine Konzentration (Clustering) von Messorten oder eine gleichmäßige Verteilung von Messorten bevorzugt wird. Eine Konzentration von Messorten kann von Vorteil sein, wenn die Messorte schlecht zugänglich sind oder es aufwändig ist, bewegliche Messgeräte über größere Strecken zu verschieben. Umgekehrt kann es von Vorteil sein, die Messorte eher gleichmäßig zu verteilen, wenn etwa jedes Messgerät relativ viel Platz einnimmt oder sich Messgeräte, die zu nahe beieinander angeordnet sind, gegenseitig stören.

Sämtliche im Folgenden offenbarten Maßnahmen bezüglich vorteilhafter Ausgestaltungen des Relevanzmaßes, der Berücksichtigung von Werten der Hilfsgröße, der Orte, an denen die Hilfsgröße gemessen wird, sowie der Wahl von Messgröße, Hilfsgröße und Probe sind ausdrücklich sowohl für das Verfahren zur tomographischen Rekonstruktion als auch für das Optimierungsverfahren geeignet. Auch kann eine Vorrichtung, die eines der Verfahren durchzuführen vermag, damit zugleich auch das andere durchführen.

In einer besonders vorteilhaften Ausgestaltung der Erfindung wird ein Relevanzmaß gewählt, dessen Wert auf insgesamt höchstens drei Vierteln, bevorzugt der Hälfte und ganz bevorzugt auf höchstens einem Viertel aller Punkte innerhalb eines beliebigen endlichen Abstands vom Mittelpunkt der Probe, auf denen es erklärt ist, einen vorgegebenen Schwellwert überschreitet. Ein solchermaßen ausgestaltetes Relevanzmaß liefert einen besonders guten zahlenmäßigen Kontrast zwischen für die Rekonstruktion aussagekräftigen und weniger aussagekräftigen Orten. Insbesondere liefert es eine Aussage darüber, in welchen Bereichen die Messungen vorteilhaft zu konzentrieren sind, wenn Detektoren oder Messzeit nur für Messungen an wenigen Orten zur Verfügung stehen. Wird die Hilfsgröße beispielsweise an Orten innerhalb der Probe gemessen, kann es sehr aufwändig sein, Sonden an eine große Anzahl solcher Orte einzubringen.

Als Schwellwert kann vorteilhaft das 1-Fache, bevorzugt das 2-Fache, des Durchschnittswerts des Relevanzmaßes über alle Punkte innerhalb des endlichen Abstands vom Mittelpunkt der Probe gewählt werden.

Jede in der Beschreibung oder in den Patentansprüchen formulierte Bedingung, bei der der Wert des Relevanzmaßes in Beziehung zu seinem Durchschnittswert auf einer Menge von Punkten gesetzt wird, ist dahingehend auszulegen, dass sie erst nach Multiplikation aller Werte des Relevanzmaßes mit einer beliebigen, von 0 verschiedenen Konstanten und/oder Addition einer beliebigen Konstanten zu allen Werten des Relevanzmaßes erfüllt zu sein braucht. Die erfindungsgemäße Wirkung hängt nicht von Absolutwerten des Relevanzmaßes ab, sondern von der Relation derjenigen Werte zueinander, die das Relevanzmaß verschiedenen möglichen Messorten für die Hilfsgröße zuordnet. Diese Relation wird weder durch Multiplikation aller Werte mit einer von 0 verschiedenen Konstanten noch durch Addition einer Konstanten zu allen Werten verändert.

Sofern im Sinne dieser Erfindung davon die Rede ist, dass das Relevanzmaß einen Wert über- oder unterschreitet, so bezieht sich dies auf den Betrag des Relevanzmaßes. Da ein Relevanzmaß im üblichen Sprachgebrauch nichtnegativ ist, wird hierauf aus Gründen der Lesbarkeit im Folgenden nicht mehr hingewiesen.

Das Relevanzmaß kann ein Maß dafür sein, wie stark der am bewerteten Ort gemessene Wert der Hilfsgröße auf Änderungen der Messgröße reagiert. Sei beispielsweise H der Vektor der an M Orten gemessenen Hilfsgröße, m der Vektor der an N Orten zu rekonstruierenden Messgröße und ist der Zusammenhang zwischen Änderungen dH von H und dm von m in linearer Näherung gegeben durch dH=S·dm mit einer M×N-Matrix S. Dann ist die Funktion

$$R_k = \sum_{l=1}^{N} S_{kl} \cdot S_{kl}$$

ein Relevanzmaß, das dem Ort, an dem der Wert k gemessen wurde, ein Maß dafür zuordnet, wie stark sich Änderungen der Messgröße m innerhalb der Probe auf den gemessenen Wert $H_k$ der Hilfsgröße auswirken: Es gilt

$$dH_k = \sum_{l=1}^{N} S_{kl} \cdot dm_l \, ,$$

worin die $dH_k$ und die $dm_l$ keine Skalare sein müssen, sondern bereits Vektoren sein können.

Das Relevanzmaß kann auch ein Maß für die Größe der auflösbaren Strukturen in der rekonstruierten Verteilung der Messgröße sein, die bei einer Änderung des am bewerteten Ort gemessenen Wertes der Hilfsgröße geändert werden. Beispielsweise lässt sich in der linearen Näherung die gesamte Rekonstruktion m der Verteilung der Messgröße als eine Linearkombination von Einzelbeiträgen schreiben, die jeweils allein auf einen gemessenen Wert $H_k$ der Hilfsgröße zurückgehen. Damit die Verteilung m der Messgröße überhaupt Strukturen mit einer vom Anwender geforderten Ortsauflösung enthält, muss sie Einzelbeiträge enthalten, die derartige feine Strukturen aufweisen. Damit sie diese Einzelbeiträge enthält, müssen die Messwerte $H_k$ der Hilfsgröße, auf die diese Beiträge zurückgehen, bei der Ermittlung der Verteilung m der Messgröße Berücksichtigung finden. In der Regel sind die Messwerte $H_k$, die besonders empfindlich auf Änderungen der Verteilung m der Messgröße reagieren, nicht dieselben, die Einzelbeiträge mit besonders feinen Strukturen zu der rekonstruierten Verteilung m beisteuern.

Das Relevanzmaß kann vorteilhaft auch ein Maß dafür sein, wie viel Information über die gesamte Verteilung der Messgröße in dem am bewerteten Ort gemessenen Wert der Hilfsgröße enthalten ist. Ein solches Maß kann beispielsweise dann besonders aussagekräftig sein, wenn unter Verwendung nur weniger Messwerte $H_k$ der Hilfsgröße ein schneller Überblick über die Messgröße m im gesamten untersuchten Probenvolumen gewonnen werden soll. Die Matrix S im oben beispielhaft genannten Relevanzmaß $R_k$ lässt sich als Singularwertzerlegung $U \cdot W \cdot V^T$ schreiben, worin U eine orthogonale Matrix, W eine Diagonalmatrix mit den Singularwerten und V eine unitäre Matrix ist. Dann ist die Funktion

$$R_k^* = \sum_{l=1}^{N} U_{kl} \cdot U_{kl}$$

ein Maß dafür, wie viel Information der gemessene Wert $H_k$ der Hilfsgröße über alle Spaltenvektoren der Matrix U und damit über die gesamte Verteilung m der Messgröße enthält.

Die hier genannten beispielhaften Kriterien für ein Relevanzmaß können je nach Anwendung beliebig miteinander kombiniert werden. So lassen sich etwa die hier beispielhaft genannten Relevanzmaße $R_k$ und $R_k^*$ zu einem einzigen Maß

$$R_k^{**} = \sum_{l=1}^{N} U_{kl} \cdot W_{ll}^{\alpha} \cdot U_{kl}$$

zusammenfassen, welches über den Parameter $\alpha$ einen beliebigen Übergang zwischen $R_k$ und $R_k^*$ ermöglicht. Ein Wert von $\alpha=1$ entspricht $R_k$, während ein Wert von $\alpha=0$ $R_k^*$ entspricht.

In einer besonders vorteilhaften Ausgestaltung der Erfindung werden bei der Ermittlung der Verteilung der Messgröße keine Werte der Hilfsgröße berücksichtigt, die an Orten gemessen wurden, für die das Relevanzmaß eine vorgegebene Schwelle unterschreitet. Diese Selektion kann vor der eigentlichen Datenaufnahme erfolgen und so zu einer Einsparung an erforderlichen Detektoren und/oder an Messzeit führen. Überraschenderweise hat sich jedoch gezeigt, dass auch eine Selektion nach der Datenaufnahme, also ein Verwerfen bereits aufgenommener Messwerte von durch das Relevanzmaß als weniger relevant bewerteten Orten, die Qualität der Rekonstruktion verbessern kann. Ist die relevante Information über die Verteilung der Messgröße bereits vorhanden, kann diese durch Hinzufügen irrelevanter Information wieder zunichte gemacht werden. Dies ist der Tatsache geschuldet, dass die Lösung eines überbestimmten Gleichungssystems grundsätzlich eine Entscheidung zwischen mehreren widersprüchlichen Lösungen ist.

Die Überbestimmtheit wird beispielsweise durch unvermeidliche Messungenauigkeiten bewirkt. Bei, rein hypothetischer, absolut präziser Messung hätte das Gleichungssystem formal mehr Gleichungen als unbekannte. Jedoch wären die überzähligen Gleichungen linear abhängig, so dass das Gleichungssystem im Endeffekt gar nicht überbestimmt wäre.

Werden in obiger Nomenklatur die für weniger relevant erachteten Werte $H_k$ der Hilfsgröße außer Acht gelassen, und wird eine entsprechende Matrix S mit weniger Zeilen neu aufgebaut, so verbessert sich die Kondition der Matrix S, die ein Maß für ihre lokale Invertierbarkeit ist. Das Gleichungssystem ist weniger durch irrelevante Information überbe-stimmt. Irrelevante Information wirkt sich im Besonderen durch die in ihr enthaltenen Messungenauigkeiten schädlich auf die Qualität der tomographischen Rekonstruktion aus.

Die vorgegebene Schwelle, unterhalb der ein Messort außer Betracht bleibt, hat in der Regel mindestens die Größenordnung des durchschnittlichen Werts des Relevanzmaßes für alle Messorte. Ihr genauer Wert kann beispielsweise durch Parameteroptimierung ermittelt werden. Das Ziel einer solchen Optimierung kann beispielsweise eine maximale Genauigkeit der tomographischen Rekonstruktion oder auch ein einstellbares Verhältnis zwischen Genauigkeit und Aufwand für die Datenaufnahme sein.

Die vorgegebene Schwelle kann das 1,5-Fache, bevorzugt das 2-Fache, des durchschnittlichen Werts des Relevanzmaßes für eine vorgegebene Menge an Messorten betragen. Diese Vorgabe kann beispielsweise darin bestehen, dass auf Grund experimenteller oder finanzieller Zwangsbedingungen Messungen nur auf einer bestimmten Menge an Messorten sinnvollerweise möglich sind.

Vorteilhaft liegen die Orte, an denen die Werte der Hilfsgröße gemessen werden, auf einer Quaderfläche, insbesondere auf einer Kubusfläche, um die Probe. Dann können beispielsweise die Messorte auf jeder Einzelfläche des Quaders von einem separaten, in zwei Dimensionen beweglichen Detektor angefahren werden.

Die Orte, an denen die Werte der Hilfsgröße gemessen werden, können aber auch auf einer elliptischen Fläche, insbesondere auf einer Kugelfläche, um die Probe liegen. Eine solche Form weist maximale Symmetrie auf. Ein einzelner, beispielsweise entlang einer Spiralbahn auf der Fläche beweglicher Detektor kann verwendet werden, um alle Messorte für die Hilfsgröße anzufahren.

Grundsätzlich gibt es aber keine Einschränkung für die Orte, an denen die Hilfsgröße gemessen wird.

In einer besonders vorteilhaften Ausgestaltung der Erfindung wird eine elektrische Stromdichte als Messgröße gewählt. Diese erzeugt ein langreichweitiges Magnetfeld, das die meisten Materialien durchdringt und somit auch außerhalb der Probe messbar ist, wo es ohne zerstörerischen Eingriff in die Probe der Messung zugänglich ist. Vorteilhaft wird in diesem Fall also ein Magnetfeld als Hilfsgröße gewählt.

Werden eine elektrische Stromdichte als Messgröße und ein Magnetfeld als Hilfsgröße gewählt, so unterliegt die elektrische Stromdichte j zudem auf Grund der Maxwellschen Gleichungen Einschränkungen. Das Magnetfeld H im Außenraum der Probe ist durch die Stromdichte j innerhalb der Probe eindeutig festgelegt. Da die Stromdichte j über die elektrische Leitfähigkeit $\sigma$ mit dem elektrischen Feld E zusammenhängt, für das gemäß der Maxwellschen Gleichungen ebenfalls Einschränkungen gelten, ist nicht jede Stromdichteverteilung j in der Probe zulässig. Die an N Punkten in der Probe gesuchte Stromdichteverteilung j kann somit unter der Zuhilfenahme der Nebenbedingung, dass sie gemäß der Maxwellschen Gleichungen zulässig sein muss, durch einen Satz $N_c$ unabhängiger Variablen mit $N_c<N$ ausgedrückt werden. Auf Grund der relativen Fehler der für die Messung der Hilfsgröße Magnetfeld verwendeten Messinstrumente gibt es ein $N_R$, für das $W_{kk} \to 0$ für $k>N_R$ angenommen werden kann. Der Zusammenhang zwischen Stromdichteverteilung j in der Probe und Magnetfeldverteilung H im Außenraum ist nun lokal eindeutig umkehrbar, wenn $N_c=N_R$ gilt, also in der oben beschriebenen linearen Näherung nach Fortlassen aller durch Messungenauigkeiten dominierten Messwerte für das Magnetfeld der Rang $N_R$ der Matrix S gleich der Anzahl $N_c$ der physikalisch unabhängigen Stromwerte ist. $N_c$ ist durch die Maschenweite festgelegt, mit der das Probenvolumen für die Aufstellung des linearen Gleichungssystems diskretisiert wird. Somit ist die durch die Maschenweite gegebene Auflösung, mit der die Stromdichteverteilung j in der Probe bestimmt werden kann, durch den relativen Fehler $f_{rel}$ der Magnetfeldmessung bestimmt. Die Untergrenze für $N_R$ ist gegeben durch die Bedingungen

$$f_{rel} < \frac{W_{NR,NR}}{W_{11}} \quad \text{und} \quad f_{rel} > \frac{W_{NR+1,NR+1}}{W_{11}}.$$

In einer besonders vorteilhaften Ausgestaltung der Erfindung wird eine Brennstoffzelle als Probe gewählt. Eine in Betrieb befindliche Brennstoffzelle ist direkten Messungen der Stromdichte in ihrem Inneren nicht oder nur schwer zugänglich, da sie hierzu verändert werden muss, was wiederum zu schwer vorhersehbaren Veränderungen der Stromdichte führt. Durch Verwendung des Magnetfelds im Außenraum als Hilfsgröße und tomographische Rekonstruktion kann die Stromdichte zerstörungs- und beeinflussungsfrei als Messgröße bestimmt werden. Gerade in einer Brennstoffzelle, die nur eine recht geringe Spannung von etwa einem Volt liefert, entstehen in technisch relevanten Anwendungen hohe Ströme der Größenordnung 50 A und mehr. Diese Ströme erzeugen Magnetfelder, die sich sehr gut außerhalb der Brennstoffzelle messen lassen.

Im Rahmen der Erfindung wurden zwei Vorrichtungen zur Durchführung des erfindungsgemäßen Verfahrens entwickelt. Jede dieser Vorrichtungen umfasst jeweils mindestens ein Messgerät für die Hilfsgröße sowie eine Auswerteeinheit zur Rekonstruktion der Verteilung der Messgröße aus den gemessenen Werten der Hilfsgröße. Das Messgerät kann dabei außerhalb der Probe angeordnet sein. Es kann aber auch innerhalb der Probe angeordnet sein; beispielsweise kann es eine Sonde sein, die in die Probe eingebracht worden ist. Es kann in der Lage sein, die Hilfsgröße an verschiedenen Orten im Raum zu messen. Es kann aber auch fest stehen, und es können Mittel, wie beispielsweise Mittel zur Drehung oder Translation der Probe, vorgesehen sein, die zu verschiedenen Zeiten die Werte der Messgröße aus verschiedenen Bereichen auf der Probe auf den Wert der Hilfsgröße am physischen Ort des Messgeräts einwirken lassen. Zur Vereinfachung wird ein Ort daher im Folgenden in einem Bezugssystem betrachtet, in dem die Probe ruht.

Die erste Ausführungsform der Vorrichtung ist gekennzeichnet durch eine Auswerteeinheit, die das Relevanzmaß auf Ortskoordinaten anzuwenden vermag. Diese Ausführungsform bietet volle Flexibilität für die Durchführung des Verfahrens: Es kann vorab entschieden werden, an welchen Orten überhaupt Messungen durchgeführt werden. Es kann aber auch eine große Sammlung an Werten $H_k$ für die Hilfsgröße aufgenommen werden, wobei erst im Nachhinein die Orte, an denen diese Werte aufgenommen wurden, mit dem Relevanzmaß bewertet werden.

Alternativ kann die Auswerteeinheit eine Liste von Ortskoordinaten enthalten, an denen bei der Durchführung des Verfahrens die Werte der Hilfsgröße bestimmt werden. Diese Ortskoordinaten können bei der Herstellung der Auswerteeinheit vorab mit Hilfe des Relevanzmaßes ausgewählt und beispielsweise mittels eines Datenträgers in die Auswerteeinheit eingebracht worden sein. Daher kann die Liste zusätzlich zu den Ortskoordinaten auch die zugehörigen Werte des Relevanzmaßes enthalten.

In einer vorteilhaften Ausgestaltung dieser Ausführungsform sind für alle Ortskoordinaten der Liste die Werte des Relevanzmaßes mindestens 1,5-mal, bevorzugt mindestens 2-mal, so groß wie an jedem anderen Ort, an dem das Relevanzmaß erklärt ist. Diese Auswahl an Ortskoordinaten erfasst den kleinen Bruchteil der möglichen Messpunkte, der die meiste Information über die gesuchte Verteilung der Messgröße innerhalb der Probe enthält.

In einer weiteren vorteilhaften Ausgestaltung dieser Ausführungsform sind für alle Ortskoordinaten der Liste die Werte des Relevanzmaßes mindestens 1,5-mal, bevorzugt mindestens 2-mal, so groß wie sein Durchschnittswert über alle Orte, an denen das Relevanzmaß erklärt ist. Auch diese Auswahl an Ortskoordinaten erfasst den kleinen Bruchteil der möglichen Messpunkte, der die meiste Information über die gesuchte Verteilung der Messgröße innerhalb der Probe enthält.

Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:

Figur 1: Schematische Skizze des Modells für eine experimentelle Direkt-Methanol-Brennstoffzelle.

Figur 2: Zweidimensionale Darstellung der Norm von Komponenten einiger Spaltenvektoren der Matrix U mit den Spaltenindizes i=1 (Teilbild a), i=7 (Teilbild b), i=14 (Teilbild c), i=19 (Teilbild d), i=26 (Teilbild e) und i=33 (Teilbild f).

Figur 3: Werte des Relevanzmaßes $R_k^*$ auf einem Quader um die modellhafte Brennstoffzelle an allen 5536 in Betracht gezogenen Orten (Teilbild a) und an den 868 Orten, an denen $R_k^*$ mindestens doppelt so groß ist wie der Durchschnitt aller 5536 insgesamt bestimmten Werte von $R_k^*$ (Teilbild b).

Figur 4: Logarithmen der Singularwerte der Matrix S, die die 5536 in Figur 3a berücksichtigen Orte umfasst (Kurve A); Logarithmen der Singularwerte der Matrix S, die lediglich die in Figur 3b berücksichtigten 868 Orte umfasst (Kurve B).

Figur 5: Logarithmus der relativen Präzision, mit der die Magnetfeldmessung durchgeführt werden muss (Ordinate), über der gewünschten Ortsauflösung der zu rekonstruierenden Stromverteilung j in Zentimetern (Abszisse).

Figur 6: Abhängigkeit der inversen Kondition der Matrix S (Ordinate) vom Anteil der möglichen Messorte für die Hilfsgröße, die diese Matrix S umfasst (Abszisse).

Figur 7: Entwicklung der größten (Teilbild a) und der kleinsten (Teilbild b) Eigenwerte von $[S^+S]$ bei der Durchführung des erfindungsgemäßen Optimierungsverfahrens am Beispiel einer Brennstoffzelle mit der Stromverteilung im Inneren als Messgröße und dem Magnetfeld im Außenraum als Hilfsgröße.

Figur 8: Darstellung der 7 % der ursprünglich gleichförmig auf der Außenfläche um die Brennstoffzelle verteilten Messorte, die mit der hier gezeigten Positionierung und Gewichtung (Flächeninhalt der Punkte) die absolute Genauigkeit der tomographischen Rekonstruktion um den Faktor 2,77 und die relative Genauigkeit um den Faktor 2,8 gegenüber der ursprünglichen Gleichverteilung steigern.

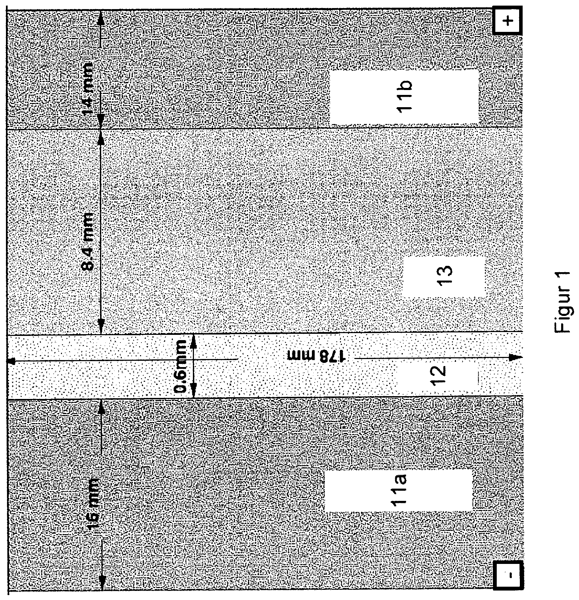

In Figur 1 ist ein Modell einer experimentellen Direkt-Methanol-Brennstoffzelle skizziert, an dem das erfindungsgemäße Verfahren simulatorisch erprobt wurde. Das Herz der Zelle ist die Membran-Elektroden-Einheit (MEA). Sie besteht aus einer porösen Schicht, einer katalytischen Schicht, einer elektrolytischen Schicht (Nafion), einer zweiten katalytischen Schicht und einer zweiten porösen Schicht. Die katalytischen Schichten enthalten Platin beziehungsweise Platin-Ruthenium und sind jeweils in porösem Graphit eingebettet. Obwohl die MEA aus 5 Schichten besteht, hat sie nur eine Dicke von 0,6 mm. Die MEA wird von zwei nichtmagnetischen Stahlplatten, einer Graphitschicht, einer dünnen Titanschicht (in die Stahlplatten integriert) und einem Teflonrahmen (in Figur 1 weggelassen) eingerahmt. Links unten in Figur 1 ist der Minuspol und rechts unten in Figur 1 der Pluspol der Brennstoffzelle angeschlossen. Der Arbeitspunkt ist mit 60 A Strom bei 0,4 A Spannungsabfall so gewählt, dass die elektrische Leitfähigkeit über die gesamte MEA homogen ist. Die Zelle hat im stromlosen Zustand eine Klemmenspannung von 0,7 V.

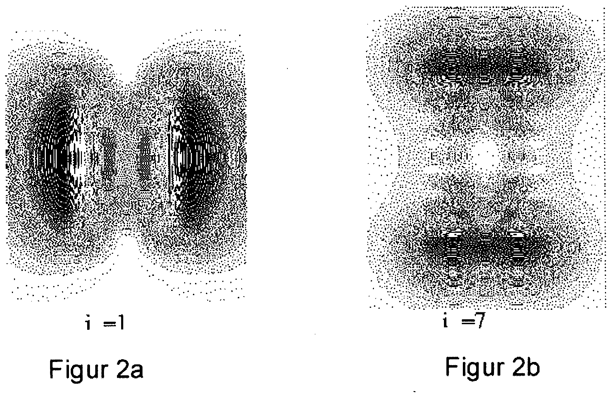

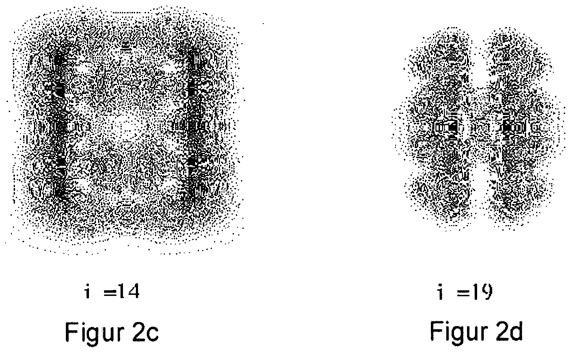

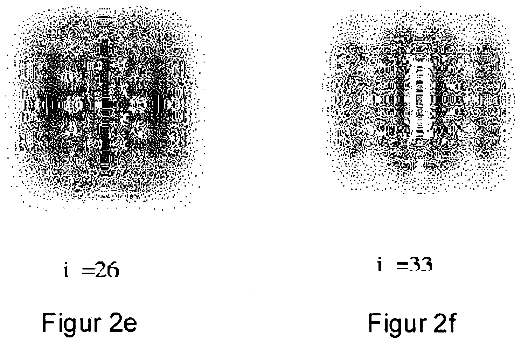

In Figur 2 ist beispielhaft die Norm einiger Komponenten von Spaltenvektoren aus der Matrix U für die Brennstoffzelle aus Figur 1 in Form zweidimensionaler Bilder aufgetragen, wobei der Schwärzungsgrad der Rasterung im Bild jeweils den Betrag der Norm angibt. Der Parameter i gibt jeweils den Spaltenindex des Vektors an. Die Rekonstruktion der Stromdichteverteilung aus den gemessenen Magnetfeldwerten ist eine Linearkombination von Spaltenvektoren aus der Matrix U. Die exemplarische Darstellung einiger dieser Spaltenvektoren in Bildform verdeutlicht daher, dass verschiedene Spaltenvektoren Informationsanteile mit stark verschiedener Ortsauflösung zur letztendlichen Rekonstruktion beisteuern. Daher ist es sinnvoll, ein Relevanzmaß zu wählen, welches ein Maß für die Größe der Strukturen in der rekonstruierten Verteilung der Messgröße Stromdichte ist, die bei einer Änderung des am bewerteten Ort gemessenen Wertes der Hilfsgröße Magnetfeld geändert werden. Für die Aufstellung der in Figur 2 analysierten Matrix S erfolgte die Diskretisierung mit einer Auflösung von 0,35 cm senkrecht zur Ebene der MEA und ansonsten mit einer Auflösung von 2,75 cm.

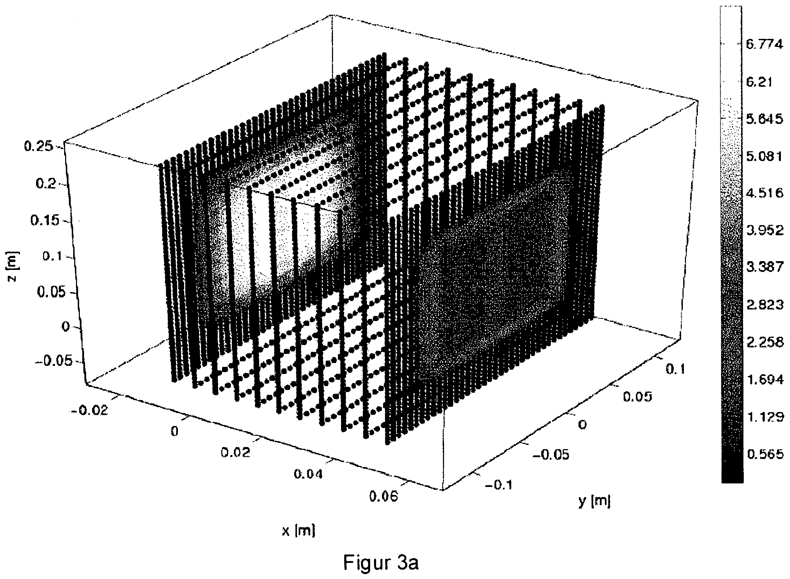

In Figur 3a_sind die Werte des Relevanzmaßes $R_k^*$ _für die Orte auf den sechs Ebenen aufgetragen, die die in Figur 1 skizzierte modellhafte Brennstoffzelle begrenzen. Das Relevanzmaß $R_k^*$ wurde hier dahingehend modifiziert, dass die $H_k$ bereits Vektoren sind. Es wurde auf zueinander parallelen Ebenen ausgewertet, die jeweils einen Abstand von 1 cm von der durch das Modell beschriebenen realen Brennstoffzelle haben. Der Gitterabstand der bewerteten Orte beträgt etwa 0,6 cm, so dass insgesamt 5536 Orte bewertet wurden. Die gemäß dem Relevanzmaß $R_k^*$ als für die Rekonstruktion am relevantesten eingestuften Messorte befinden sich auf der Vorder- und auf der Rückseite der Brennstoffzelle. Dies ist dadurch bedingt, dass sich auf diesen Ebenen die wahren Durchmesser zylindrischer Ströme am besten bestimmen lassen.

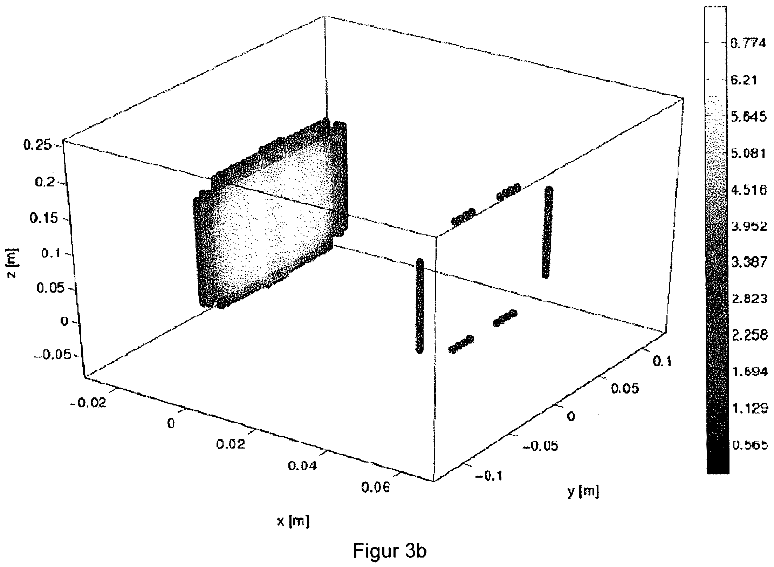

In Figur 3b sind nur die 868 Werte des modifizierten Relevanzmaßes $R_k^*$ eingetragen, die verbleiben, wenn aus Figur 3a alle Werte fortgelassen werden, die kleiner sind als das Doppelte des Durchschnitts aller insgesamt bestimmten Werte von $R_k^*$. Um den relevanten Teil der Information über die Stromverteilung zu erfassen, ist es demnach nicht erforderlich, das Magnetfeld auf einer kompletten, die Brennstoffzelle umgebenden Quaderfläche zu messen. Stattdessen genügt es, das Magnetfeld in Teilbereichen zweier Einzelflächen dieses Quaders zu messen.

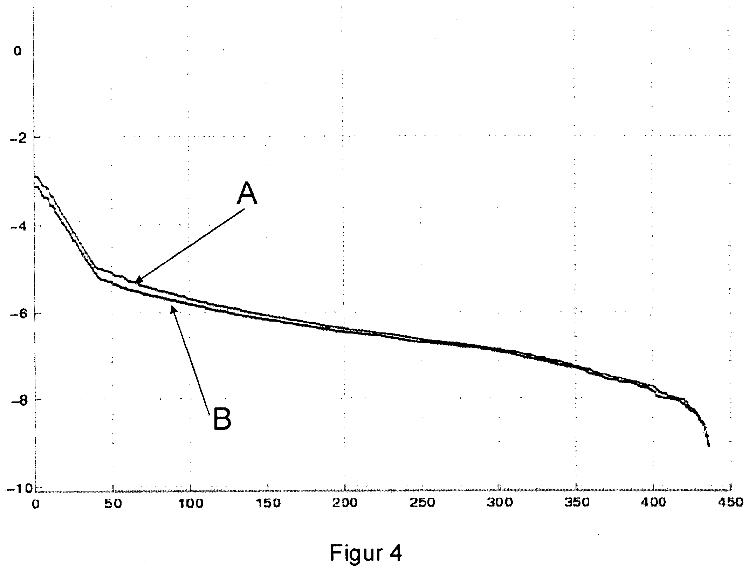

Wird das Magnetfeld lediglich an den in Figur 3b eingetragenen 868 Orten anstatt an allen 5536 in Figur 3a eingetragenen Orten bestimmt, verbessert sich die Kondition der Matrix S um den Faktor 1,4. In Figur 4 sind die Logarithmen der Singularwerte der Matrix S, die die 5536 in Figur 3a berücksichtigen Orte umfasst, (obere Kurve A), sowie die Logarithmen der Singularwerte der Matrix S, die lediglich die in Figur 3b berücksichtigten 868 Orte umfasst (untere Kurve B), über ihren jeweiligen Indexnummern aufgetragen. Da große Singularwerte schneller abnehmen als kleine, muss die Reduktion der über das Magnetfeld aufzunehmenden Datenmenge um den Faktor 6,3 nicht mit einem Verlust an Auflösung in der tomographisch rekonstruierten Stromverteilung erkauft werden.

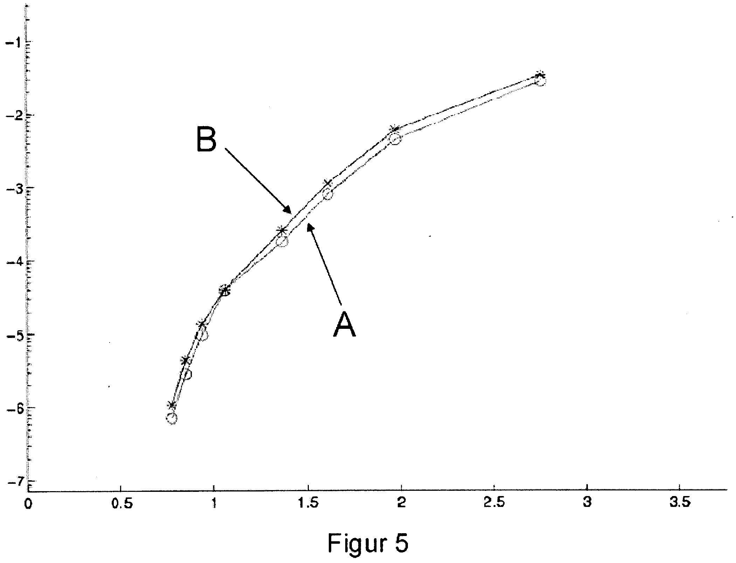

In Figur 5 ist der Logarithmus der relativen Präzision, mit der die Magnetfeldmessung durchgeführt werden muss (Ordinate), über der gewünschten Ortsauflösung der zu rekonstruierenden Stromverteilung j in Zentimetern (Abszisse) aufgetragen. Der unteren Kurve A mit Kreisen als Symbolen liegt eine Matrix S zu Grunde, die alle 5536 Orte aus Figur 3a umfasst. Der oberen Kurve B mit Sternchen als Symbolen liegt eine Matrix S zu Grunde, die nur die 868 Orte aus Figur 3b umfasst. Offenbar führt die drastische Reduktion der aufgenommenen Messpunkte dazu, dass eine vorgegebene Ortsauflösung auch mit unzuverlässigeren Messwerten für die Hilfsgröße Magnetfeld erzielt wird beziehungsweise bei einer gegebenen Messgenauigkeit für das Magnetfeld eine bessere Ortsauflösung in der rekonstruierten Stromverteilung erzielt wird.

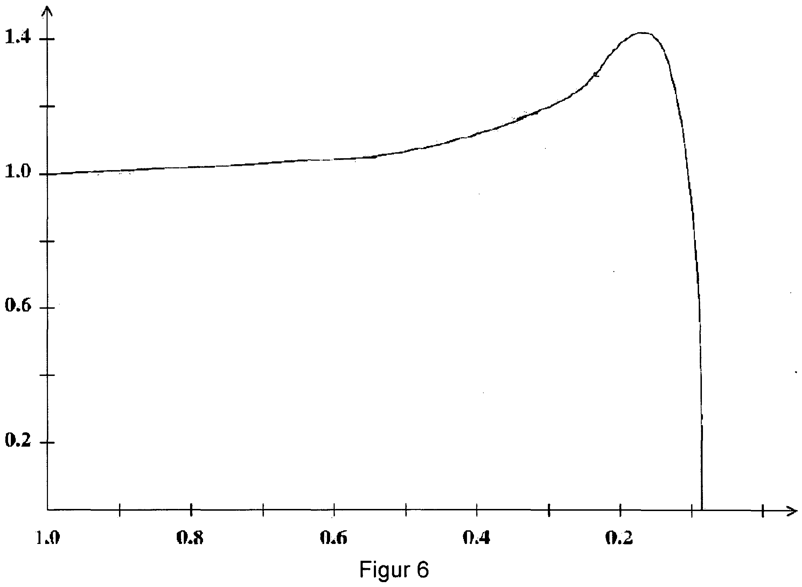

In Figur 6 ist das Inverse der Kondition der Matrix S (Ordinate), normiert auf den Wert, der sich für eine alle 5536 in Figur 3a berücksichtigen Orte umfassende Matrix S ergibt, über dem Verhältnis der Anzahl der von der Matrix S umfassten Orte zum Maximum 5536 (Abszisse) aufgetragen. Je größer das Inverse der Kondition, desto besser ist die Matrix S lokal invertierbar und desto besser wird auch die tomographische Rekonstruktion der Stromdichte. Überraschenderweise verbessern sich die Kondition und damit auch die Rekonstruktion, wenn mehr als 80 % der 5536 ursprünglich in Betracht gezogenen Messorte für das Magnetfeld unberücksichtigt bleiben (Maximum der Kurve). Bleiben noch mehr Messorte unberücksichtigt, wird also auf der Kurve ein rechts vom Maximum liegender Arbeitspunkt gewählt, so kann stufenlos ein Kompromiss zwischen Ersparnis an Aufwand für die Datenaufnahme und Qualität der tomographischen Rekonstruktion gewählt werden, vergleichbar mit der verlustbehafteten Kompression von Bild- oder Audiodateien.

Im Folgenden wird ein Ausführungsbeispiel des erfindungsgemäßen Optimierungsverfahrens näher erläutert.

In der im allgemeinen Beschreibungsteil diskutierten linearen Näherung ist der Zusammenhang zwischen Änderungen dH der Hilfsgröße H und dm der Messgröße m gegeben durch $dH = S \cdot dm$ mit einem linearen Operator S. Im Folgenden wird der Einfachheit halber angenommen, dass Messwerte für eine skalare Hilfsgröße H an $N_H$ verschiedenen Orten vorliegen. Diese $N_H$ Messwerte für H lassen sich zusammenfassen in einem Vektor **H** mit $N_H$ Komponenten. Gesucht ist die Verteilung m(**x**) einer skalaren Messgröße in Abhängigkeit vom Ort **x**. Diese ist in der linearen, diskretisierten Näherung gegeben durch eine Anzahl $N_C$ von Werten m, welche sich in einem Vektor **m** mit $N_C$ Komponenten zusammenfassen lassen. Der frei wählbare Parameter $N_C$ bestimmt hierbei die Feinheit der Diskretisierung und damit die Genauigkeit, mit der jeder der $N_C$ Messwerte m räumlich lokalisiert ist. Je größer $N_C$, desto genauer sind die Werte m lokalisiert und desto besser ist die Ortsauflösung, mit der die Verteilung m(x) bestimmt werden kann.

In dieser Näherung ergibt sich ein Wert $H_k$ der Hilfsgröße aus allen Werten $m_v$ der Messgröße über

$$H_k = \sum_{j=1}^{N_C} S_{k,j} \cdot m_j \, ,$$

worin $S_{k,j}$ die Elemente einer Matrixdarstellung **S** des linearen Operators S sind. Jeder Index k repräsentiert in dieser Matrixdarstellung den Ort $x_k$, an der der k'te Wert $H_k = H(x_k)$ der Hilfsgröße aufgenommen wurde. Somit ist $S_{k,j}$ eine Abkürzung für $S_{x_k,j}$.

Wie oben im allgemeinen Beschreibungsteil ausgeführt, sind für die Genauigkeit, mit der der Vektor **m** der Messgröße aus dem Vektor **H** der Hilfsgröße bei vorgegebener Genauigkeit δH für die Werte $H_k$ rekonstruiert werden kann, die Eigenwerte des Operators bzw. der Matrix **S⁺S** maßgeblich. Diese Eigenwerte sind auch dafür maßgeblich, inwieweit eine tomographische Rekonstruktion überhaupt möglich ist, das heißt, ob überhaupt zu jedem Vektor **m** der Messgröße ein Vektor **H** der Hilfsgröße existiert, aus dem durch Lösung des linearen Gleichungssystems **H=S·m** auf m zurückgeschlossen werden kann.

Es ist nun zweckmäßig für die Durchführung von Optimierungen, jedem Ort **x** einen Beitrag zur Matrix **S⁺S** zuordnen zu können. Wir definieren ρ(**x**) als die lokale Dichte von Messorten um den Ort **x**. Diese lokale Dichte wirkt wie folgt auf jedes Element [**S⁺S**]$_{i,j}$ des Matrixprodukts [**S⁺S**]:

$$\left[\mathbf{S^+S}\right]_{i,j} = \frac{1}{N_H} \sum_{k=1}^{N_H} S_{i,\mathbf{x}_k}^+ \cdot S_{\mathbf{x}_k,j} = \int_W \frac{dw}{|W|} \cdot \rho(x) \cdot S_{i,\mathbf{x}}^+ \cdot S_{\mathbf{x},j} \, ,$$

worin W die Kurve, die Fläche oder das Volumen ist, innerhalb dessen überhaupt Messungen stattfinden, und

$$|W| = \int_W dw$$

die Länge der Kurve bzw. den Flächen- oder Volumeninhalt von W angibt. In diesem Ansatz ist ρ(**x**) die Dichtefunktion, die variiert und optimiert werden kann Sie steht für den Beitrag, den jeder Ort **x** innerhalb von W zum Produkt [**S⁺S**] leistet. Die Normierung von [**S⁺S**] ist hier auf die unten angegebene physikalisch sinnvolle Normierung für ρ(**x**) abgestimmt.

Der Ausdruck für [**S⁺S**]$_{i,j}$ ist die Darstellung einer Faltung der Dichtefunktion ρ(**x**) mit einer Funktion f(S), die gegeben ist durch

$$f(S) = S_{i,\mathbf{x}}^+ \cdot S_{\mathbf{x},j} \, .$$

**S⁺** und **S** gehen in Form von Komponentendarstellungen $S_{\mathbf{x},j}$ bzw. $S_{i,\mathbf{x}}^+$ in diese Funktion ein. Für **S⁺** und **S** entspricht eine Koordinate (i oder j) einem Index der gewünschten Komponente [**S⁺S**]$_{i,j}$ des Matrixprodukts [**S⁺S**]. Die andere Koordinate ist entsprechend dem Ort **x** gesetzt, über den in der Faltung integriert wird.

ρ(**x**) kann nicht nur als Dichtefunktion, sondern auch als Relevanzmaß aufgefasst werden. Dieses ordnet jedem Ort x ein Gewicht zu, mit dem an diesem Ort gewonnene Messwerte in die tomographische Rekonstruktion eingehen sollten, um die Qualität dieser Rekonstruktion im Hinblick auf das bei der Optimierung von ρ(**x**) verwendete Funktional zu maximieren.

Für die Dichtefunktion wird die physikalisch sinnvolle Normierung

$$\int_W \frac{dw}{|W|} \rho(\mathbf{x}) = 1$$

gewählt. Die in der linearen Näherung angenommene diskrete Verteilung von $N_H$ Orten $\mathbf{x}_k$, an denen die Hilfsgröße H gemessen wird, entspricht einer Dichtefunktion

$$\rho(x) = \sum_{k=1}^{N_H} \frac{|W| \cdot A_k}{N_H} \cdot \delta(\mathbf{x} - \mathbf{x}_k) \quad \text{mit} \quad \sum_k \frac{A_k}{N_H} = 1,$$

die der physikalisch sinnvollen Normierung genügt. Die $A_k$ sind die Amplituden der $\delta$-Funktionen, die deren Gewichte in der Dichtefunktion $\rho(\mathbf{x})$ repräsentieren.

Die Integralschreibweise ermöglicht es beispielsweise, Messwerte zwischen den Orten $\mathbf{x}_k$, an denen sie tatsächlich aufgenommen wurden, zu interpolieren und die daraus erhaltene Dichtefunktion $\rho(\mathbf{x})$ zu glätten.

Da die erzielbare Genauigkeit und die Störanfälligkeit der tomographischen Rekonstruktion von den Eigenwerten von $[\mathbf{S}^+\mathbf{S}]$ abhängen, läuft die anmeldungsgemäß zu lösende Aufgabe in dem hier beschriebenen Formalismus auf die Suche nach derjenigen Dichtefunktion $\rho(\mathbf{x})$ hinaus, die zu einer Matrix $[\mathbf{S}^+\mathbf{S}]$ mit einem in bestimmter Weise vorteilhaften Eigenwertespektrum führt.

Mit der obigen Darstellung lässt sich $[\mathbf{S}^+\mathbf{S}]$ aus $\rho(\mathbf{x})$ berechnen. Durch die konkrete Aufgabenstellung ist nun eine mathematische Bedingung für das Eigenwertspektrum von $[\mathbf{S}^+\mathbf{S}]$ vorgegeben, die möglichst optimal erfüllt sein soll. In der Regel liegt eine solche Bedingung in Form eines Funktionals vor, das entweder von der ganzen Matrix $[\mathbf{S}^+\mathbf{S}]$ oder von einem oder mehreren ihrer Elemente abhängt. In dieses Funktional ist die obige Darstellung, in der $[\mathbf{S}^+\mathbf{S}]$ als Integral über $\rho(\mathbf{x})$ ausgedrückt wird, einzusetzen. Das Funktional von $[\mathbf{S}^+\mathbf{S}]$ wird dadurch zu einem Funktional von $\rho(\mathbf{x})$, also zu einem Funktional der gesuchten Verteilung von Messorten, an denen zweckmäßigerweise die Werte der Hilfsgröße zu bestimmen sind.

Durch die Wahl von S als Operator in dem erfindungsgemäßen Optimierungsverfahren wird in der Faltung jedem Ort $\mathbf{x}$ ein Maß dafür zugeordnet, wie stark sich Änderungen der Messgröße m innerhalb der Probe auf den an diesem Ort gemessenen Wert H($\mathbf{x}$) der Hilfsgröße auswirken, also wie relevant der Ort x für die tomographische Rekonstruktion ist. Alternativ kann durch Wahl von U aus der Singularwertzerlegung $\mathbf{U} \cdot \mathbf{W} \cdot \mathbf{V}^T$ von S jedem Ort $\mathbf{x}$ in der Faltung ein Maß dafür zugeordnet werden, wie viel Information ein an diesem Ort gemessener Wert H($\mathbf{x}$) der Hilfsgröße über die gesamte Verteilung m($\mathbf{x}$) der Messgröße enthält. Die Wahl von S oder U (oder einer beliebigen Linearkombination hieraus) ermöglicht es somit, das Optimierungsziel in Richtung einer höheren Genauigkeit (S) oder in Richtung eines besseren Gesamtüberblicks über die Verteilung der Messgröße (U) zu verschieben.

Im Folgenden wird ein Ausführungsbeispiel für die iterative Durchführung des Optimierungsverfahrens beschrieben. Sei $[\mathbf{S}^+\mathbf{S}]_{n-1}$ die Matrix $[\mathbf{S}^+\mathbf{S}]$, die aus der Iteration n-1 der Dichtefunktion $\rho(\mathbf{x})$ hervorgeht. Da die Matrix $[\mathbf{S}^+\mathbf{S}]_{n-1}$ hermitesch ist, ist sie unitär diagonalisierbar. Sie lässt sich somit in eine Diagonalmatrix $\mathbf{K}_{n-1}$ verwandeln, deren Einträge die Eigenwerte von $[\mathbf{S}^+\mathbf{S}]_{n-1}$ sind. Diese Einträge sind gegeben durch

$$K_{n-1|i} = \int_W \frac{dw}{|W|} \cdot \rho_{n-1}(x) \cdot \mathbf{T}_n \cdot S_{i,\mathbf{x}}^+ \cdot S_{\mathbf{x},i} \cdot \mathbf{T}_n^+,$$

worin $\mathbf{T}_n$ die unitäre Transformation ist, die $[\mathbf{S}^+\mathbf{S}]_{n-1}$ diagonalisiert. Das Matrixprodukt im Integral lässt sich vereinfachen, so dass

$$K_{n-1|i} = \int_W \frac{dw}{|W|} \cdot \rho_{n-1}(x) \cdot \left| \sum_m S_{\mathbf{x},m} \mathbf{T}_{n|m,i}^+ \right|^2.$$

Für die n-te Iteration der Dichtefunktion $\rho(x)$ wird nun der Ansatz

$$\rho_n(\mathbf{x}) = \rho_{n-1}(\mathbf{x}) \cdot (1 + \varepsilon \cdot \tau_n(\mathbf{x}))$$

gemacht, worin $\tau_n(\mathbf{x})$ die Korrekturfunktion ist. Die Dichtefunktion $\rho(\mathbf{x})$ wird somit beim Übergang von der Iteration n-1 auf die Iteration n um ein punktweises Produkt ihrer selbst mit der Korrekturfunktion geändert. Von der Korrekturfunktion

$\tau_n(\mathbf{x})$ wird gefordert, dass sie orthonormal zu $\rho_{n-1}(\mathbf{x})$ ist, also

$$\int\limits_W \frac{dw}{|W|} \rho_{n-1}(\mathbf{x})\tau_n(\mathbf{x}) = 0$$

sowie

$$\int\limits_W \frac{dw}{|W|} \tau_n^2(\mathbf{x})\rho_{n-1}(\mathbf{x}) = 1.$$

Dadurch ist sichergestellt, dass $\rho_n(\mathbf{x})$ der oben eingeführten physikalisch sinnvollen Normierung

$$\int\limits_W \frac{dw}{|W|} \rho_n(\mathbf{x}) = 1$$

genügt.

In diesem speziellen Ausführungsbeispiel wird danach gefragt, inwieweit sich beim Übergang von der Iteration n-1 auf die Iteration n die Eigenwerte in der Diagonalmatrix **K** ändern. Hierzu wird nährungsweise angenommen, dass sich bei diesem Übergang in dem obigen Ausdruck für $K_{n-1|i}$ nur $\rho_{n-1}(\mathbf{x})$ zu $\rho_n(\mathbf{x})$ ändert. Einsetzen des obigen Iterationsansatzes für $\rho_n(\mathbf{x})$ liefert

$$K_{n|i} = K_{n-1|i} + \varepsilon \int\limits_W \frac{dw}{|W|} \rho_{n-1(x)}\tau_n(x)\left|\sum_m S_{\mathbf{x},m}\mathbf{T}_{n|m,i}^+\right|^2 + O(\varepsilon^2).$$

Die Funktionen

$$d_{n|i} = \left|\sum_m S_{\mathbf{x},m}\mathbf{T}_{n|m,i}^+\right|^2$$

bilden eine Basis des Funktionenraums, so dass $\tau_n(\mathbf{x})$ nach ihnen entwickelt werden kann:

$$\tau_n(\mathbf{x}) = \sum_{v=0}^{N_C+1} \alpha_v d_{n|v} \,,$$

worin

$$d_{M|N_C+1}(\mathbf{x}) = \text{const.}$$

festzusetzen ist. Der Wert dieser Konstanten ist frei im Rahmen der Nebenbedingung, dass $\tau_n(\mathbf{x})$ orthonormal zu $\rho_{n-1}(\mathbf{x})$ ist. Seine Größenordnung folgt aus den Notwendigkeiten, die sich bei der numerischen Berechnung ergeben.

Die hier gewählte Basis des Funktionenraums ist für die Berechnung der $K_{n|i}$ hinreichend, da für alle Vektoren **x**, die nicht in dieser Basis entwickelt werden können, der Beitrag zum Integralterm im Ausdruck für $K_{n|i}$ verschwindet.

Für die Änderung der Eigenwerte gilt

$$K_{n|i} = K_{n-1|i} + \varepsilon \sum_{v=0}^{N_C+1} X_{n|i,v} \alpha_v + O(\varepsilon^2),$$

worin

$$X_{n|i,j} = \int_W \frac{dw}{|W|} d_{n|i}(\mathbf{x}) \rho_{n-1}(\mathbf{x}) d_{n|j}(\mathbf{x}).$$

Damit $\tau_n(\mathbf{x})$ orthonormal zu $\rho_{n-1}(\mathbf{x})$ ist, ist zusätzlich als Nebenbedingung gefordert

$$K_{n|N_C+1} = K_{n-1|N_C+1}.$$

Die Nebenbedingungen für die Orthonormalität lassen sich schreiben als

$$\sum_{v=0}^{N_C+1} X_{M|N_C+1,v} \cdot \alpha_v = 0 \quad (\text{Orthogonalität})$$

$$\sum_{v,\mu} \alpha_v \cdot \alpha_\mu \cdot X_{n|\mu,v} = 1 \quad (\text{Normalität})$$

Dieser Formalismus ist gültig, solange [S$^+$S] keine entarteten Eigenwerte hat. Er gibt an, wie $\tau$ gewählt werden muss, um die Eigenwerte von [S$^+$S] in die gewünschte Richtung zu lenken. Das Optimierungsziel ist hierzu als Funktional zu formulieren, das mindestens von einem Eigenwert von [S$^+$S] abhängt. Ein solcher Eigenwert lässt sich, wie oben beschrieben, durch die Entwicklungskoeffizienten $\alpha_v$ ausdrücken, die die Zusammensetzung der Korrekturfunktionen $\tau$ aus den Basisfunktionen d beschreiben. Somit sind in dem Funktional, das das Optimierungsziel mathematisch beschreibt, letztendlich diese Entwicklungskoeffizienten $\alpha_v$ die einzigen freien Parameter.

Jedes solche Funktional, das einen Eigenwert der Matrix [S$^+$S] enthält, enthält dabei auch mindestens ein Element dieser Matrix. Beim Diagonalisieren von [S$^+$S] werden durch die unitäre Transformation $\mathbf{T}_n$ die Eigenwerte von [S$^+$S] als Linearkombinationen der Elemente von [S$^+$S] dargestellt. Da sowohl diese Elemente als auch die Elemente von $\mathbf{T}_n$ sich wiederum, wie oben beschrieben, als Faltung der Verteilung $\rho(\mathbf{x})$ von Messorten mit einer Verkettung der Operatoren S und S$^+$ ausdrücken lassen, enthält jedes Funktional, das einen Eigenwert der Matrix [S$^+$S] enthält, somit automatisch auch eine solche Faltung.

Die Eigenwerte von [S$^+$S] sind die Singularwerte von $\sqrt{\rho(\mathbf{x})} \cdot \mathbf{S}$. Die Erfindung bezieht sich also auch auf ein Verfahren zur Bestimmung der optimalen Verteilung von Messorten, an denen zwecks tomographischer Rekonstruktion einer Messgröße innerhalb der Probe eine der Messung zugängliche Hilfsgröße zu messen ist, wobei die Verteilung von Messorten auf den Extremwert eines Funktionals hin optimiert wird, welches mindestens einen Singularwert eines Operators enthält, der ein Produkt aus einer Potenz der Verteilung von Messorten mit dem Operator S beinhaltet, welcher jeder möglichen Verteilung der Messgröße eine Verteilung der Hilfsgröße zuordnet. Die Potenz ist in diesem Fall ½.

Ist das Optimierungsziel beispielsweise eine maximale absolute Genauigkeit, so ist es das Ziel, den kleinsten, also den $N_C$'ten, Eigenwert von [S$^+$S] möglichst groß werden zu lassen. Es soll daher die Änderung dieses Eigenwerts maximiert werden. Ein Beispiel für ein Funktional, das den Schritt von der Iteration n-1 auf die Iteration n im Hinblick auf dieses Optimierungsziel beschreibt, ist

$$F_n = \sum_{v=0}^{N_C+1} X_{n|N_C,v} \, \alpha_v - \mu_0 \sum_{v=0}^{N_C+1} X_{n|N_C+1} \cdot \alpha_v -$$

$$- \mu_1 \left[ \sum_{v,\mu=0}^{N_C+1} \alpha_\mu \cdot X_{n|\mu,v} \cdot \alpha_v - 1 \right]$$

Hierin ist die erste Summe die Veränderung des $N_C$'ten Eigenwerts beim Übergang von der Iteration n-1 auf die Iteration n in 1. Ordnung Störungstheorie.

Um die optimale Veteilung $\rho(\mathbf{x})$ von Messorten aufzufinden, ist der Wert dieses Funktionals in Abhängigkeit der $\alpha_v$ zu maximieren. $\mu_0$ und $\mu_1$ sind Lagrange-Parameter, die so zu wählen sind, dass die Nebenbedingungen erfüllt werden. Dieses Funktional lässt sich noch dahingehend verallgemeinern, dass bei der Optimierung des kleinsten Eigenwerts von [$\mathbf{S^+S}$] auch die Auswirkungen der hierzu durchgeführten Änderungen an [$\mathbf{S^+S}$] (über die Änderung der Dichtefunktion p(x), durch die sich [$\mathbf{S^+S}$] ausdrücken lässt) auf die anderen Eigenwerte von [$\mathbf{S^+S}$] berücksichtigt werden. Dadurch kann insbesondere vermieden werden, dass im Laufe der Iterationen Entartung auftritt. Im Falle von Entartung kann die Veränderung der Eigenwerte von einer Iteration zur nächsten nicht mehr, wie oben beschrieben, in 1. Ordnung Störungstheorie genähert werden.

Die Iterationen sind zu beenden, sobald das Optimum von $F_n$ wiederholt keinen positiven Wert für die Änderung des kleinsten, $N_C$'ten Eigenwerts mehr zulässt, weil dann keine Verbesserung mehr in Bezug auf diesen Eigenwert erzielt werden kann. Der Wert von $\varepsilon$ bestimmt die Stärke der Korrektur und steuert damit das Tempo des Optimierungsprozesses. Da auf Grund der Orthonormalitätsbedingung für die Korrekturfunktion $\tau$ diese Funktion ihr Vorzeichen wechseln muss, gibt es zu jeder stetigen Korrekturfunktion $\tau(\mathbf{x})$ ein maximales $\varepsilon_{max}>0$ mit

$$\varepsilon_{max} = \max_{\varepsilon} \left(1 - \varepsilon \tau(\mathbf{x}) \geq 0 \quad \forall \mathbf{x}\right),$$

bei dessen Überschreiten der oben beschriebene Ansatz für den Übergang von der Iteration n-1 auf die Iteration n nicht mehr funktioniert.

Ist das Optimierungsziel eine möglichst große relative Genauigkeit, so kann dieses Ziel beispielsweise über das Funktional

$$F_n = \sum_{v=0}^{N_C+1} X_{n|N_C,v} \, \alpha_v - \frac{K_{n-1|N_C}}{K_{n-1|0}} \sum_{v=0}^{N_C+1} X_{n|0,v} \cdot \alpha_v -$$

$$- \mu_0 \sum_{v=0}^{N_C+1} X_{n|N_C+1} \cdot \alpha_v - \mu_1 \left[ \sum_{v,\mu=0}^{N_C+1} \alpha_\mu \cdot X_{n|\mu,v} \cdot \alpha_v - 1 \right]$$

angestrebt werden. Hierin sind die ersten beiden Summenterme ein Maß für die Änderung des Verhältnisses zwischen dem größten und dem kleinsten Eigenwert von [$\mathbf{S^+S}$] und damit auch ein Maß für das Verhältnis zwischen dem größten und dem kleinsten Singularwert von $\mathbf{S}$. Die Änderung wurde wie beim Optimierungsziel der maximalen absoluten Genauigkeit in 1. Ordnung Störungstheorie genähert.

Es wird nun ein Ausführungsbeispiel für die Vermeidung ungünstiger Messorte gegeben. Sei a($\mathbf{x}$) eine im Raum der möglichen Verteilungen von Messorten definierte Gewichtsfunktion. Dann bewirkt die Nebenbedingung

$$\int_W \frac{dw}{|W|} \rho(\mathbf{x}) a(\mathbf{x}) = A, \quad \min_{\mathbf{x} \in W} a(\mathbf{x}) \leq A \leq \max_{\mathbf{x} \in W} a(\mathbf{x}),$$

die eine Faltung von $\rho(\mathbf{x})$ mit der Gewichtungsfunktion a($\mathbf{x}$) enthält, eine Verteilung, die sich bei einem vorgegebenen Wert von A nahe dem Minimum von a($\mathbf{x}$) um kleine Werte von a($\mathbf{x}$) konzentriert. Bei einem vorgegebenen Wert von A nahe dem Maximum von a($\mathbf{x}$) konzentriert sich diese Verteilung dagegen um große Werte von a($\mathbf{x}$). Es können auch mehrere Nebenbedingungen dieser Art aufgestellt werden. Eine Nebenbedingung dieser Art führt im Funktional für die Optimierung zu einem Term mit einem Lagrange-Parameter. Bei der Optimierung eines Funktionals, das Lagrange-Parameter enthält, ist das erhaltene Optimum eine Funktion dieser Lagrange-Parameter. Das Endergebnis ist das Optimum, welches für diejenigen Werte der Lagrange-Parameter erhalten wurde, mit denen die Nebenbedingungen erfüllt sind.

Ein Ausführungsbeispiel für eine Nebenbedingung, mit der die Konzentration von Messorten gesteuert werden kann, ist die Bedingung

$$\int_W \frac{dw}{|W|} \rho^2(\mathbf{x}) = B,$$

die eine Faltung der Dichtefunktion $\rho(\mathbf{x})$ mit sich selbst enthält. Je kleiner B ist, desto stärker wird eine gleichmäßige Verteilung bevorzugt. Je größer B ist, desto stärker tritt ein Clustering von Messorten auf.

Im Folgenden wird ein alternativer Formalismus für die iterative Durchführung des Optimierungsverfahrens, der auch bei Entartung oder Fastentartung von Eigenwerten gültig ist, gegeben. Dieser Formalismus geht von einem Optimierungsziel aus, das am Schwerpunkt (Summe geteilt durch Anzahl) der Eigenwerte von [$\mathbf{S^+S}$] beziehungsweise einer in Betracht gezogenen interessierenden Teilmenge dieser Eigenwerte ansetzt. Mit der Abkürzung

$$d_{n|1}(\mathbf{x}) = \frac{1}{N_\eta} \sum_{i=N_C-N_\eta+1}^{N_C} \left| \sum_m S_{\mathbf{x},m} T_{n|m,i}^+ \right|^2$$

ist die Änderung $\Delta\lambda_S$ des Schwerpunkts $\lambda_S$ der in Betracht gezogenen $N_\eta$ Eigenwerte in 1. Ordnung Störungstheorie

$$\Delta\lambda_S = \varepsilon \cdot \int_W \frac{dw}{|W|} d_{n|1}(\mathbf{x}) \cdot \rho_{n-1}(\mathbf{x}) \cdot \tau_n(\mathbf{x}) + O(\varepsilon^2).$$

Die Korrekturfunktion $\tau_n(\mathbf{x})$ lässt sich dann schreiben als

$$\tau_n(\mathbf{x}) = \sum_{v=1}^{2} \alpha_v \cdot d_{n|v}(\mathbf{x}),$$

worin

$$d_{n|2}(\mathbf{x}) = \text{const.}$$

festzulegen ist. Der Wert dieser Konstanten ist frei im Rahmen der Nebenbedingung, dass $\tau_n(\mathbf{x})$ orthonormal zu $\rho_{n-1}(\mathbf{x})$ ist. Seine Größenordnung folgt aus den Notwendigkeiten, die sich bei der numerischen Berechnung ergeben.

Die hier gewählte zweidimensionale Basis des Funktionenraums für $\tau_n(\mathbf{x})$ ist für die Berechnung der Änderung $\Delta\lambda_S$ des Schwerpunkts $\lambda_S$ hinreichend: Alle Funktionen, die nicht in dem von dieser Basis aufgespannten Raum liegen, sind orthogonal zu $\tau_n(\mathbf{x})$ und liefern daher keinen Beitrag zur Änderung $\Delta\lambda_S$ des Schwerpunkts $\lambda_S$. Mit der Matrix

$$X_{n|i,j} := \int_W \frac{dw}{|W|} d_{n|i}(\mathbf{x}) \cdot \rho_{n-1}(\mathbf{x}) \cdot d_{n|j}(\mathbf{x})$$

lässt sich die Änderung $\Delta\lambda_S$ des Schwerpunkts $\lambda_S$ ausdrücken als

$$\Delta\lambda_S = \varepsilon \cdot \sum_{\nu=1}^{2} X_{n|1,\nu} \cdot \alpha_\nu$$

mit den Nebenbedingungen

$$\sum_{\nu=1}^{2} X_{n|2,\nu} \cdot \alpha_\nu = 0$$

zur Gewährleistung der Orthogonalität zwischen $\tau_n(\mathbf{x})$ und $\rho_{n-1}(\mathbf{x})$ und

$$\sum_{\nu,\kappa=1}^{2} \alpha_\kappa \cdot X_{n|\kappa,\nu} \cdot \alpha_\nu = 1$$

zur Gewährleistung der physikalisch sinnvollen Normierung für $\rho_n(\mathbf{x})$.

Hieraus ergibt sich, wie $\tau_n(\mathbf{x})$ gewählt werden muss, um den Schwerpunkt $\lambda_S$ in die gewünschte Richtung zu lenken. Das Optimierungsziel ist hierzu als Funktional zu formulieren, das von diesem Schwerpunkt $\lambda_S$ abhängt. Der Schwerpunkt $\lambda_S$ lässt sich, wie oben beschrieben, durch die Entwicklungskoeffizienten $\alpha_\nu$ ausdrücken, die die Zusammensetzung der Korrekturfunktion $\tau_n(\mathbf{x})$ aus den Basisfunktionen $d_\nu$ beschreiben. Somit sind in einem Funktional, das das Optimierungsziel mathematisch beschreibt, letztendlich diese Entwicklungskoeffizienten die einzigen freien Parameter. Nebenbedingungen können in einem solchen Funktional durch Terme mit Lagrange-Parametern berücksichtigt werden.

Jedes solche Funktional, das den Schwerpunkt $\lambda_S$ enthält, hängt dabei auch von mindestens einem Element der Matrix [$\mathbf{S^+S}$] ab, da die Eigenwerte von den Matrixelementen abhängen. Diese Matrixelemente lassen sich wiederum, wie oben beschrieben, als Faltung der Verteilung $\rho_n(\mathbf{x})$ von Messorten mit einer Funktion f(S) des Operators S ausdrücken lassen (siehe die obige Darstellung für die Elemente [$\mathbf{S^+S}$]$_{i,j}$). Daher enthält jedes Funktional, das einen Eigenwert von [$\mathbf{S^+S}$] enthält, und erst recht jedes Funktional, das einen Schwerpunkt einer Menge solcher Eigenwerte enthält, automatisch eine solche Faltung.

Ist das Optimierungsziel beispielsweise eine maximale absolute Genauigkeit, so ist es das Ziel, den Schwerpunkt $\lambda_{S,u}$ der kleinsten Eigenwerte von [$\mathbf{S^+S}$] und damit auch die Änderung $\Delta\lambda_{S,u}$ dieses Schwerpunkts möglichst groß werden zu lassen. Als kleinste Eigenwerte von [$\mathbf{S^+S}$] werden nur solche Eigenwerte von [$\mathbf{S^+S}$] in Betracht gezogen, die höchstens um einen Faktor p größer sind als der kleinste Eigenwert von [$\mathbf{S^+S}$]. Je größer p ist, desto stabiler ist der Schwerpunkt $\lambda_{S,u}$ gegen einzelne Ausreißer unter den in Betracht gezogenen Eigenwerten und desto ungenauer ist dieser Schwerpunkt $\lambda_{S,u}$ zugleich bestimmt. Im Interesse einer möglichst großen Genauigkeit sind daher möglichst kleine Werte von p anzustreben. Je kleiner p ist, desto kleiner ist allerdings wegen der abnehmenden Stabilität von $\lambda_{S,u}$ und damit auch von $\Delta\lambda_{S,u}$ auch der maximal mögliche Durchgriff $\varepsilon$ der Optimierung und desto langsamer konvergiert die Optimierung. Der Wert von p liegt typischerweise in der Größenordnung 1,1.

Ein Beispiel für ein Funktional, das den Schritt von der Iteration n-1 auf die Iteration n im Hinblick auf dieses Optimierungsziel beschreibt, ist

$$F_n = \sum_{\nu=1}^{2} X_{n|1,\nu} \cdot \alpha_\nu - \mu_0 \sum_{\nu=1}^{2} X_{n|2,\nu} \cdot \alpha_\nu - \mu_1 \left[ \sum_{\nu,\mu=1}^{2} \alpha_\mu \cdot X_{n|\mu,\nu} \cdot \alpha_\nu - 1 \right]$$

.

Hierin ist die erste Summe proportional zur Veränderung von $\lambda_{S,u}$ beim Übergang von der Iteration n-1 auf die Iteration n in 1. Ordnung Störungstheorie. Um die optimale Verteilung $\rho(\mathbf{x})$ von Messorten aufzufinden, ist der Wert dieses Funktionals in Abhängigkeit der $\alpha_v$ zu maximieren. $\mu_0$ und $\mu_1$ sind Lagrange-Parameter, die so zu wählen sind, dass die Nebenbedingungen erfüllt werden. Das erhaltene Optimum ist also eine Funktion dieser Lagrange-Parameter. Das Endergebnis ist das Optimum, welches für diejenigen Werte der Lagrange-Parameter erhalten wurde, mit denen die Nebenbedingungen erfüllt sind.

Die Iterationen sind zu beenden, sobald das Optimum von $F_n$ über eine Anzahl von Iterationen hin keinen positiven Wert für $\Delta\lambda_{S,u}$ liefert, weil dann keine Verbesserung mehr zu erwarten ist. Der in $\Delta\lambda_{S,u}$ steckende Wert von $\varepsilon$ bestimmt die Stärke der Korrektur und steuert damit das Tempo des Optimierungsprozesses. Da auf Grund der Ortho-normalitätsbedingung für die Korrekturfunktion $\tau_n(\mathbf{x})$ diese Funktion ihr Vorzeichen wechseln muss, gibt es zu jeder solchen Korrekturfunktion $\tau_n(\mathbf{x})$ ein maximales $\varepsilon_{max}>0$, bei dessen Überschreiten der oben beschriebene Ansatz für den Übergang von der Iteration n-1 auf die Iteration n nicht mehr funktioniert.

Ist das Optimierungsziel eine möglichst große relative Genauigkeit, so kann dieses Ziel beispielsweise erreicht werden über das Funktional

$$F_n = \sum_{v=1}^{3} X_{n|1,v} \cdot \alpha_v - \frac{\lambda_{Su}}{\lambda_{So}} \sum_{v=1}^{3} X_{n|2,v} \cdot \alpha_v - \mu_0 \sum_{v=1}^{3} X_{n|3,v} \cdot \alpha_v -$$

$$\vdots \quad - \mu_1 \left[ \sum_{v,\mu=1}^{3} \alpha_\mu \cdot X_{n|\mu,v} \cdot \alpha_v - 1 \right]$$

.

Hierin sind $\lambda_{Su}$ und $\lambda_{So}$ jeweils die Schwerpunkte der kleinsten und der größten in Betracht gezogenen Eigenwerte von $[\mathbf{S}^+\mathbf{S}]$. Analog zur Menge der kleinsten in Betracht gezogenen Eigenwerte werden als größte Eigenwerte nur diejenigen Eigenwerte in Betracht gezogen, die höchstens um einen Faktor q unterhalb des größten Eigenwerts liegen. Typische Werte für q liegen in der Größenordnung 0,9. Je kleiner q und je größer damit die Bandbreite derjenigen Eigenwerte, die als größte Eigenwerte in Betracht gezogen werden, desto stabiler ist der Schwerpunkt dieser Menge an größten Eigenwerten und desto ungenauer ist er zugleich bestimmt.

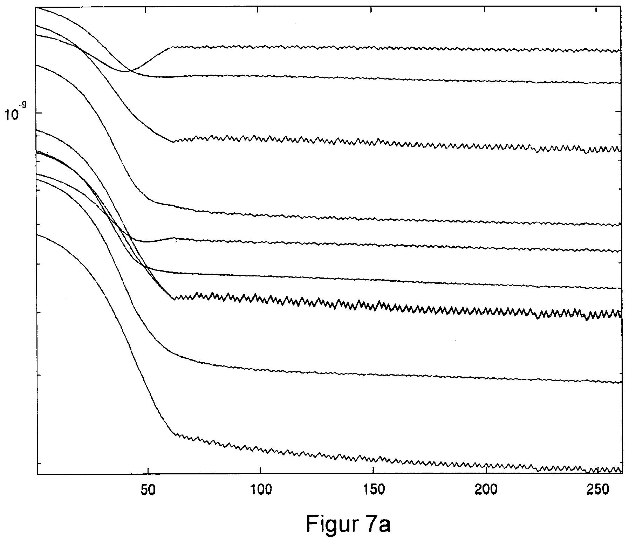

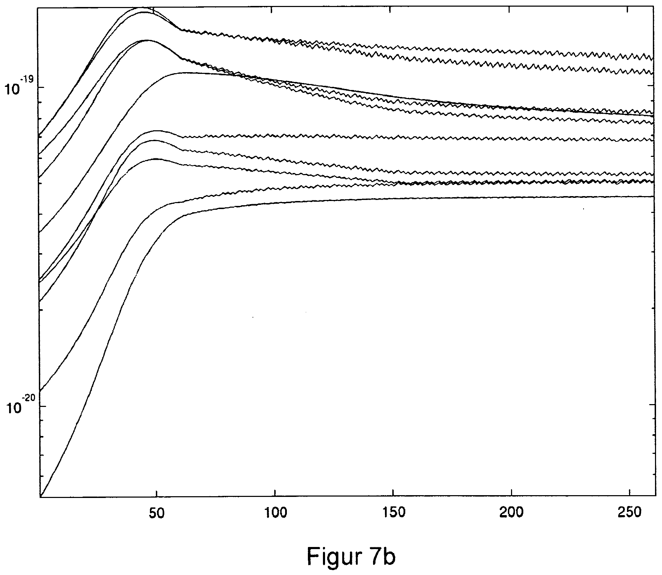

Figur 7a zeigt die Entwicklung der größten und Figur 7b die Entwicklung der kleinsten Eigenwerte von $[\mathbf{S}^+\mathbf{S}]$ für einen Operator S, der typisch ist für das Problem der tomographischen Rekonstruktion der Stromverteilung in einer Brennstoffzelle (Messgröße) aus im Außenraum der Brennstoffzelle gemessenen Magnetfeldwerten (Hilfsgröße). Das Optimierungsverfahren wurde iterativ durchgeführt, und das Optimierungsziel war eine möglichst große Erhöhung des Schwerpunkts $\lambda_{S,u}$ der kleinsten Eigenwerte von $[\mathbf{S}^+\mathbf{S}]$. Aufgetragen sind jeweils die Eigenwerte über der Anzahl der Iterationen. Die Eigenwerte wurden nach jeder Iteration n bestimmt, indem eine Singularwertzerlegung der sich aus der jeweiligen Verteilung $\rho_n(\mathbf{x})$ von Messorten ergebenden Matrix $[\mathbf{S}^+\mathbf{S}]_n$ durchgeführt wurde. Der kleinste Eigenwert von $[\mathbf{S}^+\mathbf{S}]$ wird im Laufe der Iterationen um einen Faktor von etwa 8 erhöht, was für die besagte Anwendung an der Brennstoffzelle eine typische Größenordnung zu sein scheint. Dies bedeutet eine Steigerung der absoluten Genauigkeit um den Faktor $\sqrt{8}$. Gleichzeitig wurde das Verhältnis $\lambda_u/\lambda_o$ um den Faktor 9 erhöht. Dies bedeutet eine Steigerung der relativen Genauigkeit um den Faktor $\sqrt{9}=3$.

Ist die einzige Bedingung, dass die absolute Genauigkeit insgesamt nicht schlechter werden darf, so kann für das in Figur 7 dargestellte Ausführungsbeispiel des erfindungsgemäßen Optimierungsverfahrens an der Brennstoffzelle die Anzahl der Messorte drastisch reduziert werden. Hierfür wurde nach der optimalen Verteilung $\rho(\mathbf{x})$ von Messorten auf einer Außenfläche gefragt, die in jeder Dimension einen Abstand von 1 cm von der Brennstoffzelle hat. Die Verteilung wurde mit dem erfindungsgemäßen Optimierungsverfahren für eine feste Anzahl $N_H$ von 6.700 Messorten ermittelt, wobei als Startwert für die erste Iteration eine gleichförmige Verteilung der Messorte über die gesamte Außenfläche gewählt wurde. Nach der Optimierung wurden alle Messorte verworfen, an denen $\rho(\mathbf{x})$ einen vorgegebenen Schwellwert unterschritt. Als Schwellwert wurde in diesem Fall der Durchschnittswert von $\rho(\mathbf{x})$ gewählt. Die verbliebenen Messorte entsprachen einer reduzierten Dichte $\rho_R(\mathbf{x})$ von Messorten, die jeweils mit einer $\delta$-Funktion in diese Dichte eingingen. Unter Beibehaltung der Anzahl und der Positionen dieser $\delta$-Funktionen wurde nun die reduzierte Dichte $\rho_R(\mathbf{x})$ auf die physikalisch sinnvolle Normierung für $\rho(\mathbf{x})$ gebracht erneut dem Optimierungsverfahren unterzogen. Dabei waren die einzigen noch freien Parameter die Gewichte, mit denen die einzelnen $\delta$-Funktionen in die reduzierte Dichte $\rho_R(\mathbf{x})$ eingingen.

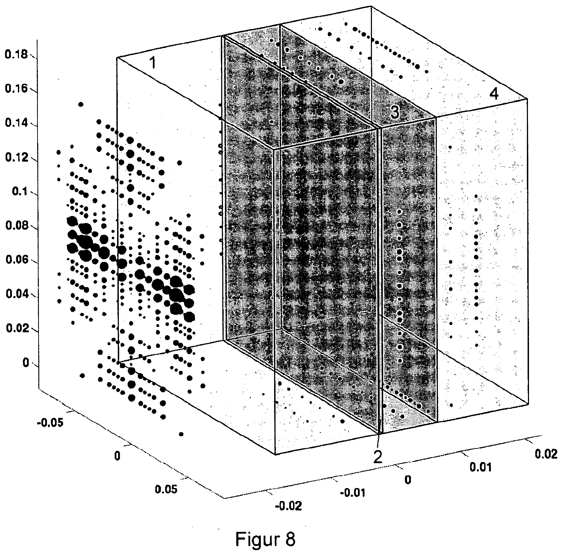

Das Ergebnis ist in Figur 8 dargestellt. In dieser Figur ist die Brennstoffzelle als Würfel skizziert, wobei die unterschiedlichen Schattierungen unterschiedlichen Funktionsschichten der Brennstoffzelle entsprechen. Schicht 1 ist Stahl-Titan, Schicht 2 die Membran-Elektroden-Einheit (MEA), Schicht 3 Graphit und Schicht 4 Stahl. Auf der Außenfläche sind die verbliebenen Messorte durch Punkte markiert, wobei die Flächeninhalte der Punkte um so größer sind, je größer das dem entsprechenden Messort durch die zweite Optimierung zugewiesene Gewicht ist. Sämtliche Messorte am oberen Ende der Gewichtsskala befinden sich auf nur einer von 6 Seitenflächen der untersuchten würfelförmigen Außenfläche. Zugleich ist die weitaus überwiegende Anzahl der überhaupt verbliebenen Messorte auf dieser einen Seitenfläche konzentriert.

Mit der in Figur 8 dargestellten Verteilung von 460 verbliebenen (von ursprünglich 6.700) Messorten konnte die Anzahl der Messorte um 93 % reduziert und zugleich die absolute Genauigkeit um den Faktor 2,77 gesteigert werden, wobei die verbliebenen Messorte durch die zweite Optimierung sehr verschiedene Gewichte erhalten haben. Zugleich konnte die relative Genauigkeit um den Faktor 2,8 gesteigert werden.

Unter Preisgabe von nur wenig absoluter Genauigkeit kann die praktische Durchführung der Messung noch weiter vereinfacht werden, indem nur die Messorte auf der einen Seitenfläche in Betracht gezogen werden, auf der die weitaus meisten nach der ersten Optimierung verbliebenen Messorte konzentriert sind. Dann reicht ein einziger scannender Detektor, der diese Seitenfläche abarbeitet, um die dreidimensionale Stromverteilung innerhalb der Brennstoffzelle tomographisch zu bestimmen. Ein scannender Detektor, der die Messorte nacheinander abarbeitet, kann an diesem Ausführungsbeispiel Brennstoffzelle verwendet werden, weil sich dort zeitunabhängige stationäre Betriebszustände einstellen.

**Patentansprüche**

1. Verfahren zur Optimierung einer Dichte $\rho(\boldsymbol{x})$ der Verteilung der Messpunkte von Detektoren zur Messung der Werte einer Hilfsgröße, aus denen die Werte einer Messgröße innerhalb einer Probe bestimmt werden, wobei der Zusammenhang zwischen der Verteilung der Messgröße innerhalb der Probe und der Hilfsgröße um einen Arbeitspunkt im Raum der möglichen Verteilungen der Messgröße linearisiert wird, so dass die Werte der Hilfsgröße mit den Werten der Messgröße in einem linearen Zusammenhang stehen, dergestalt, dass die Werte der Hilfsgröße sich durch Multiplikation eines linearen Operators $S$ in Matrixdarstellung mit den Werten der Messgröße ergeben, wobei $N_c$ Werte der Messgröße als unabhängige Variable aufgefasst werden können und der Rang der Matrix zu dem linearen Operator $S$ gleich dem Wert $N_c$ ist und wobei mindestens eine erste Nebenbedingung in Form einer Normierung der Dichte der Verteilung festgelegt wird, **gekennzeichnet durch** eine auf Grund von a priori-Informationen festgesetzte Verteilung der Messpunkte als Startwert für ein iterativ durchgeführtes Verfahren und **dadurch, dass** die Dichte der Messpunkte in diesem Iterationsverfahren optimiert wird, wobei die Änderung der Dichte der Messpunkte $\rho_n(\boldsymbol{x})$ im Iterationsschritt n aus der Dichte der Messpunkte $\rho_{n-1}(\boldsymbol{x})$ aus dem Iterationsschritt n-1 durch die folgenden Schritte bestimmt wird:

   a) Berechnung der Elemente eines matrixförmigen Operators $[S^+S]_{n-1}$, welcher mindestens die Integration über einen Bereich W, innerhalb dessen Messungen stattfinden, über das Produkt der Dichte der Verteilung der Messpunkte $\rho_{n-1}(\boldsymbol{x})$ aus dem Iterationsschritt n-1 mit dem Operator $S$ und dem zu diesem Operator $S$ adjungierten Operators $S^+$ an diesen Messpunkten umfasst

   b) Bestimmung einer unitären Transformation $T_n$, welche den in Schritt a) bestimmten Operator $[S^+S]_{n-1}$ diagonalisiert

   c) Bestimmung von Funktionen $d_{n|i}$, welche jeweils den quadrierten Absolutbetrag der Summe über eine Spalte i des Produktes des linearen Operators $S$ in Matrixdarstellung mit der adjungierten Matrix zu der unitären Transformation $T_n$ umfassen

   d) Entwicklung einer Korrekturfunktion $\tau_n(\boldsymbol{x})$ nach den Funktionen $d_{n|i}$, wobei diese Entwicklung eine Summe über die Funktionen $d_{n|i}$, jeweils multipliziert mit noch zu bestimmenden Entwicklungskoeffizienten $\alpha_i$ umfasst

   e) Aufstellung eines Funktionals, welches mindestens einen Term für die Änderung des kleinsten Eigenwertes des Operators $[S^+S]_{n-1}$, sowie als Nebenbedingungen, welche jeweils mit einem Lagrange-Parameter multipliziert werden, mindestens zwei Terme umfasst, einen ersten Term zur Normierung der Korrekturfunktion $\tau_n(\boldsymbol{x})$ gemäß $\int_W \rho_{n-1}(\boldsymbol{x})\tau_n^2(\boldsymbol{x})\,dw/W = 1$, und einen zweiten Term, welcher die zweite Nebenbedingung in Form der Orthogonalitätsbedingung $\int_W \rho_{n-1}(\boldsymbol{x})\tau_n(\boldsymbol{x})\,dw/W = 0$ umfasst, wobei die Lagrange-Parameter so zu wählen sind, dass die Nebenbedingungen erfüllt sind, und wobei zur Aufstellung der Terme die in Schritt d) genannte Entwicklung der Korrekturfunktion $\tau_n(\boldsymbol{x})$ verwendet wird

   f) Bestimmung der Werte der Koeffizienten $\alpha_i$, bei denen dieses Funktional seinen maximalen Wert annimmt

   g) Berechnung der neuen Dichte $\rho_n(\boldsymbol{x})$ der Verteilung der Messpunkte als eine Summe, welche mindestens zwei Summenglieder umfasst, wobei das erste Summenglied die Dichte $\rho_{n-1}(\boldsymbol{x})$ aus dem vorherigen Iterationsschritt umfasst und das zweite Summenglied das Produkt aus der Korrekturfunktion $\tau_n(\boldsymbol{x})$ mit der Dichte $\rho_{n-1}(\boldsymbol{x})$ und mit einem nicht negativen Parameter $\varepsilon$ umfasst, dessen Wert unterhalb des maximalen positiven Wertes $\epsilon_{max} = \max_\varepsilon(1 - \varepsilon\tau_n(\boldsymbol{x}) \geq 0 \; \forall \; \boldsymbol{x})$ liegt
und die durch die Schritte a) - g) bestimmte Dichte $\rho_n(\boldsymbol{x})$ als Anfangsverteilung für den nächsten Iterationsschritt gemäß der Punkte a)-g) verwendet wird und die Iterationsschritte wiederholt werden, bis mindestens das Optimum des Funktionals in Schritt e) keinen positiven Wert für die Änderung des kleinsten Eigenwertes des Operators $[S^+S]_n$ mehr zulässt.

2. Verfahren nach Anspruch 1, **dadurch gekennzeichnet, dass** alle Werte der Dichte $\rho_n(\boldsymbol{x})$ aus Schritt g) verworfen werden, welche unter einem Schwellwert liegen und anschließend die so erhaltene reduzierte Dichte $\rho_R(\boldsymbol{x})$ gemäß der ersten Nebenbedingung normiert und erneut dem Iterationsverfahren unterworfen wird.

3. Verfahren nach einem der vorhergehenden Ansprüche, **dadurch gekennzeichnet, dass** eine Dichte gewählt wird, deren Wert auf insgesamt höchstens drei Vierteln aller Punkte innerhalb eines beliebigen endlichen Abstands vom Mittelpunkt der Probe, auf der sie erklärt ist, einen vorgegebenen Schwellwert überschreitet.

4. Verfahren nach einem der vorhergehenden Ansprüche, **dadurch gekennzeichnet, dass** eine Dichte gewählt wird, deren Wert auf der Hälfte oder höchstens einem Viertel aller Punkte innerhalb eines beliebigen endlichen Abstands vom Mittelpunkt der Probe, auf der sie erklärt ist, einen vorgegebenen Schwellwert überschreitet.

5. Verfahren nach einem der vorhergehenden Ansprüche, **dadurch gekennzeichnet, dass** als Schwellwert der Durchschnittswert der Dichte $\rho_n(\boldsymbol{x})$ über alle Punkte innerhalb des endlichen Abstands vom Mittelpunkt der Probe gewählt wird.

6. Verfahren nach einem der vorhergehenden Ansprüche, **dadurch gekennzeichnet, dass** der Extremwert des Funktionals unter der Nebenbedingung bestimmt wird, dass eine Faltung der Verteilung der Messorte mit einer ortsabhängigen Gewichtsfunktion einen vorgegeben Wert annimmt.

7. Verfahren nach einem der vorhergehenden Ansprüche, **dadurch gekennzeichnet, dass** der Extremwert des Funktionals unter der Nebenbedingung bestimmt wird, dass eine Faltung der Verteilung der Messorte mit sich selbst einen vorgegeben Wert annimmt.

8. Verfahren nach einem der vorhergehenden Ansprüche, **dadurch gekennzeichnet, dass** als erste Nebenbedingung die Dichte auf Eins normiert wird: $\int_W dw \frac{1}{W} \rho(\boldsymbol{x}) = 1$

9. Verfahren nach einem der vorhergehenden Ansprüche, **dadurch gekennzeichnet, dass** als Startwert für das iterative Verfahren eine homogene Verteilung gewählt wird.

10. Verfahren nach einem der vorhergehenden Ansprüche, **dadurch gekennzeichnet, dass** die Einträge in der Zeile i und Spalte j des Operators $[S^+S]$ zu einer Dichte $\rho(\boldsymbol{x})$ jeweils berechnet werden gemäß: $[S^+S]_{i,j} = \int_W dw \frac{1}{W} \rho(\boldsymbol{x}) S_{i,\boldsymbol{x}}^+ S_{\boldsymbol{x},j}$, wobei in der Matrix $S_{x,j}$ jede Zeile mit einem der Messpunkte korrespondiert.

11. Verfahren nach einem der vorhergehenden Ansprüche, **dadurch gekennzeichnet, dass** die Funktionen $d_{n|i}$ aus Schritt c) in Anspruch 1 mit Hilfe der unitären Transformation $T_n$ berechnet werden gemäß: $d_{n|i} = |\sum_m S_{\boldsymbol{x},m} T_{n|m,i}^+|^2$

12. Verfahren nach einem der vorhergehenden Ansprüche, **dadurch gekennzeichnet, dass** die Korrekturfunktion $\tau_n(\boldsymbol{x})$ aus Schritt d) in Anspruch 1 berechnet wird gemäß: $\tau_n(x) = \sum_{i=0}^{N_c+1} \alpha_i d_{n|i}$, insbesondere unter der Nebenbedingung, dass die in Anspruch 11 genannte Funktion $d_{n|i}$ zum Index $i = N_c + 1$ einen konstanten Wert annimmt.

13. Verfahren nach einem der vorhergehenden Ansprüche, **dadurch gekennzeichnet, dass** das zu maximierende Funktional aus Schritt e) in Anspruch 1 mindestens den Term $\sum_{v=0}^{N_c+1} X_{n|N_c,v} \alpha_v$ und als Nebenbedingungen, welche jeweils mit einem Lagrange-Parameter multipliziert werden, die Terme $\sum_{\nu=0}^{N_c+1} X_{n|N_c+1,\nu}\alpha_\nu$ und $\sum_{\nu,\mu=0}^{N_c+1} \alpha_\mu X_{n|\mu,\nu}\alpha_\nu$ umfasst, mit $X_{n|i,j} = \int_W dw \frac{1}{W} d_{n|i}(x)\rho_{n-1}(x)d_{n|j}(x)$.

14. Verfahren nach Anspruch 13, **dadurch gekennzeichnet, dass** das zu maximierende Funktional aus Schritt e) in Anspruch 1 zusätzlich den Term $\frac{K_{n-1|N_c}}{K_{n-1|0}} \sum_{\nu=0}^{N_c+1} X_{n|0,\nu}\alpha_\nu$ umfasst, wobei $K_{n-1|N_c}$ den kleinsten Eigenwert und $K_{n-1|0}$ den größten Eigenwert des Operators $[S^+S]_{n-1}$ bezeichnet.

15. Verfahren nach einem der Ansprüche 1 bis 10, **dadurch gekennzeichnet, dass** eine erste Funktionen $d_{n|1}$ der Funktionen $d_{n|i}$ aus Schritt c) in Anspruch 1 mit Hilfe der unitären Transformation $T_n$ für eine natürliche Zahl $N_\eta <$ $N_c$ berechnet wird gemäß: $d_{n|1}(x) = \frac{1}{N_\eta} \sum_{i=N_c-N_\eta+1}^{N_c} |\sum_m S_{x,m} T_{n|m,i}^+|^2$ und eine zweite Funktion $d_{n|2}$ gleich einer Konstanten ist.

16. Verfahren nach Anspruch 15, **dadurch gekennzeichnet, dass** die Korrekturfunktion $\tau_n(x)$ aus Schritt d) in Anspruch 1 mit den Hilfsfunktionen $d_{n|1}$, $d_{n|2}$ aus Anspruch 15 berechnet wird gemäß: $\tau_n(x) = \sum_{\nu=1}^{2} \alpha_\nu d_{n|\nu}(x)$

17. Verfahren nach Anspruch 16, **dadurch gekennzeichnet, dass** das zu maximierende Funktional aus Schritt e) in Anspruch 1 mindestens den Term $\sum_{\nu=1}^{2} X_{n|1,\nu}\alpha_\nu$ und als Nebenbedingungen, welche jeweils mit einem Lagrange-Parameter multipliziert werden, die Terme $\sum_{\nu=1}^{2} X_{n|2,\nu}\alpha_\nu$ und $\sum_{\nu,\mu=1}^{2} \alpha_\mu X_{n|\mu,\nu}\alpha_\nu$ umfasst, mit $X_{n|i,j} = \int_W dw \frac{1}{W} d_{n|i}(x)\rho_{n-1}(x)d_{n|j}(x)$ mit den Hilfsfunktionen $d_{n|1}$, $d_{n|2}$ aus Anspruch 15.

18. Verfahren nach Anspruch 16, **dadurch gekennzeichnet, dass** das zu maximierende Funktional aus Schritt e) in Anspruch 1 mindestens den Term $\sum_{\nu=1}^{3} X_{n|1,\nu}\alpha_\nu$ sowie den Term $\frac{\lambda_{S_u}}{\lambda_{S_o}} \sum_{\nu=1}^{3} X_{n|2,\nu}\alpha_\nu$ und als Nebenbedingungen, welche jeweils mit einem Lagrange-Parameter multipliziert werden, die Terme $\sum_{\nu=1}^{3} X_{n|3,\nu}\alpha_\nu$ und $\sum_{\nu,\mu=1}^{3} \alpha_\mu X_{n|\nu,\mu}\alpha_\nu$ umfasst, wobei $\lambda_{S_u}$ die Summe der kleinsten Eigenwerte des durch die jeweilige Dichte bestimmten Operators $[S^+S]$ geteilt durch deren Anzahl und $\lambda_{S_o}$ die Summe dessen größter Eigenwerte geteilt durch deren Anzahl ist und die $X_{n|i,j}$ wie in Anspruch 13 definiert sind.

19. Verfahren nach einem der vorhergehenden Ansprüche, **dadurch gekennzeichnet, dass** eine Stromdichte als Messgröße und das durch diese Stromdichte außerhalb einer Probe erzeugte Magnetfeld als Hilfsgröße verwendet wird und/oder eine Brennstoffzelle als Probe gewählt wird.

20. Verfahren nach einem der vorhergehenden Ansprüche, **dadurch gekennzeichnet, dass** bei der Ermittlung der Verteilung der Messgröße keine Werte der Hilfsgröße berücksichtigt werden, die an Orten gemessen wurden, für die die durch das Verfahren bestimmte Dichteverteilung einen vorgegebenen Schwellwert unterschreitet.

21. Verfahren nach einem der vorhergehenden Ansprüche, **dadurch gekennzeichnet, dass** die Orte, an denen die Werte der Hilfsgröße gemessen werden, auf einer Quaderfläche, insbesondere auf einer Kubusfläche, oder auf einer elliptischen Fläche, insbesondere auf einer Kugeloberfläche, um die Probe liegen.

22. Vorrichtung zur Durchführung des Verfahrens nach einem der vorigen Ansprüche, umfassend mindestens ein Messgerät für die Hilfsgröße sowie eine Auswerteeinheit zur Rekonstruktion der Verteilung der Messgröße aus den gemessenen Werten der Hilfsgröße, **gekennzeichnet durch** eine Auswerteeinheit, ausgebildet zur Durchführung des Verfahrens nach einem der vorigen Ansprüche, die durch das Verfahren bestimmte Dichteverteilung auf Ortskoordinaten anzuwenden vermag.

23. Vorrichtung zur Durchführung des Verfahrens nach einem der Ansprüche 1-21 umfassend mindestens ein Messgerät für die Hilfsgröße sowie eine Auswerteeinheit zur Rekonstruktion der Verteilung der Messgröße aus den gemessenen Werten der Hilfsgröße, **gekennzeichnet durch** eine Auswerteeinheit, ausgebildet zur Durchführung des Verfahrens nach einem der Ansprüche 1-21, die eine Liste von Ortskoordinaten enthält, an denen bei der Durchführung des Verfahrens die Werte der Hilfsgrößen bestimmt werden, wobei diese Liste insbesondere zusätzlich zu den Ortskoordinaten Werte der durch das Verfahren bestimmten Dichteverteilung enthalten kann.

24. Vorrichtung zur Durchführung des Verfahrens nach einem der Ansprüche 22 bis 23, **dadurch gekennzeichnet, dass** für alle Ortskoordinaten der Liste die Werte der durch das Verfahren bestimmten Dichteverteilung mindestens 1,5-mal, bevorzugt mindestens 2-mal, so groß sind wie

   • die Werte dieser Dichteverteilung an jedem anderen Ort, an dem diese Dichteverteilung erklärt ist, und/oder
   • der Durchschnittswert dieser Dichteverteilung über alle Orte, an denen sie erklärt ist.

**Claims**

1. Method for optimising a density $\rho(x)$ of distribution of the measurement points from detectors for measuring the values for an auxiliary variable, from which the values for a measurement variable within a sample are determined, in which the connection between the distribution of the measurement variable within the sample and the auxiliary variable around a working point in the area of possible distributions of the measurement variable is linearized, so that the values for the auxiliary variable have a linear connection with the values for the measurement variable in such a way that the values for the auxiliary variable result from multiplying a linear operator S in matrix notation with the values for the measurement variable, in which $N_c$ values for the measurement variable may be taken as independent variables and the rank of the matrix at the linear operator S is equal to the value $N_c$ and in which at least a first secondary condition in the form of standardisation of the density of distribution is established, **characterised by** a distribution of the measurement points established based on a priori information as the starting value for a method carried out iteratively and **characterised in that** the density of the measurement points is optimised in this iterative method, in which the change in density of the measurement points $\rho_n(x)$ in the iterative step n is determined from the density of the measurement points $\rho_{n-1}(x)$ from the iterative step n-1 by the following steps:

   a) Calculation of the elements of a matrix type operator $[S^+S]_{n-1}$, which comprises at least integration over an area W, within which measurements take place, over the product of the density of distribution of the measurement points $\rho_{n-1}(x)$ from the iterative step n-1 with the operator S and the operator $S^+$ adjoined to this operator $S$ at these measurement points
   b) Determination of a unitary transformation $T_n$, which diagonalizes the operator $[S^+S]_{n-1}$ determined in step a)
   c) Determination of functions $d_{n|i}$, which each comprise the squared absolute value for the sum over a column i of the product of the linear operator S in matrix notation with the adjoined matrix at the unitary transformation $T_n$
   d) Development of a correction function $\tau_n(x)$ according to the functions $d_{n|i}$, in which this development comprises a sum over the functions $d_{n|i}$, each multiplied with development coefficients $\alpha_i$ still to be determined
   e) Formation of a functional, which comprises at least one term for the change in the smallest intrinsic value of the operator $[S^+S]_{n-1}$ and as secondary conditions, which are each multiplied with a Lagrange multiplier, at least two terms, a first term for standardising the correction function $\tau_n(x)$ according to $f_W \rho_{n-1}(x) \tau_n^2(x)\, dw/W = 1$, and a second term, which comprises the second secondary condition in the form of the orthogonal condition $f_W \rho_{n-1}(x) \tau_n(x)\, dw/W = 0$, in which the Lagrange multiplier must be selected so that the secondary conditions are met, and in which the development of the correction function $\tau_n(x)$ indicated in step d) is used for the formation of the terms
   f) Determination of the values for the coefficients $\alpha_i$, where this functional takes on its maximum value
   g) Calculation of the new density $\rho_n(x)$ of distribution of the measurement points as a sum, which comprises at least two terms, in which the first term of the sum comprises the density $\rho_{n-1}(x)$ from the previous iterative step and the second term of the sum comprises the product from the correction function $\tau_n(x)$ with the density $\rho_{n-1}(x)$ and with a non-negative parameter $\varepsilon$, the value of which is below the maximum positive value

   $$\varepsilon_{max} = \max_\varepsilon(1 - \varepsilon\tau_n(x) \geq 0 \uplus x)$$ and the density $\rho_n(x)$ determined by steps a) - g) is used as the initial distribution for the next iterative step according to points a) - g) and the iterative steps are repeated, until at least the optimum of the functional in step e) no longer allows a positive value for the change in the smallest intrinsic value of the operator $[S^+S]n$.

2. Method according to claim 1, **characterised in that** all values for density $\rho_n(x)$ from step g) are discarded, which lie below a threshold value, and then the reduced density $\rho_R(x)$ obtained in this way is standardised according to the first secondary condition and then subject to the iterative method again.

3. Method according to one of the previous claims, **characterised in that** a density is selected, the value of which exceeds a preset threshold value over a total of at most three quarters of all points within any final distance from the middle point of the sample, on which it is stated.

4. Method according to one of the previous claims, **characterised in that** a density is selected, the value of which exceeds a preset threshold value on half or at most a quarter of all points within any final distance from the middle point of the sample, on which it is stated.

5. Method according to one of the previous claims, **characterised in that** the average value for the density $\rho_n(x)$ **over all points within the final distance from the middle point of the sample is selected as the threshold value.**

6. Method according to one of the previous claims, **characterised in that** the extreme value for the functional is determined under the secondary condition that a convolution of the distribution of the measurement points with a locally dependent weight function takes on a preset value.

7. Method according to one of the previous claims, **characterised in that** the extreme value for the functional is determined under the secondary condition that a convolution of the distribution of the measuring points with itself takes on a preset value.

8. Method according to one of the previous claims, **characterised in that** the density at one is standardised **as a first secondary condition:**

$$\int_W dw\underline{1}\, \rho(x) = 1$$

9. Method according to one of the previous claims, **characterised in that** a homogenous distribution is selected as the starting value for the iterative method.

10. Method according to one of the previous claims, **characterised in that** the entries in the line i and column j of the operator $[S^+S]$ are each calculated at a density $p(x)$ according to: $[S^+S]_{i,j} = \int_W dw\underline{1}\, \rho(x) S^+_{i,x} S_{x,j}$, in which in the matrix $S_{x,j}$ each line corresponds to one of the measurement points.

11. Method according to one of the previous claims, **characterised in that** the functions $d_{n|i}$ from step c) in claim 1 are calculated using the unitary transformation $T_n$ according to: $d_{n|i} = |\Sigma_m S_{x,m} T^+_{n|m,i}|^2$

12. Method according to one of the previous claims, **characterised in that** the correction function $\tau_n(x)$ **from step** d) in claim 1 is calculated according to: $T_n(x) = \Sigma_{i=0}^{Nc+1} \alpha_i d_{n|i}$, particularly under the secondary condition that the function $d_{n|i}$ indicated in claim 11 takes on a constant value at the index $i = N_c + 1$.

13. Method according to one of the previous claims, **characterised in that** the functional to be maximised from step e) in claim 1 comprises at least the term $\Sigma_{v=0}^{Nc+1} X_{n|Nc,v}\alpha_v$ and as secondary conditions, which are each multiplied with a Lagrange multiplier, the terms $\Sigma_{v=0}^{Nc+1} X_{n|Nc+1,v}\alpha_v$ and $\Sigma_{v,\mu=0}^{Nc+1}\alpha_\mu X_{n|\mu,v}\alpha_v$ with $X_{n|i,j} = \int_W dw\underline{1}\, d_{n|i}(x)\rho_{n-1}(x)d_{n|j}(x)$.

14. Method according to claim 13, **characterised in that** the functional to be maximised from step e) in claim 1 also comprises the term $\dfrac{K_{n-1|Nc}}{} \Sigma_{v=0}^{Nc+1}$

$K_{n-1|0}$ $X_{n|0,v}\alpha_v$, in which $K_{n-1|Nc}$ is the smallest intrinsic value and $K_{n-1|0}$ indicates the largest intrinsic value of the operator $[S^+S]_{n-1}$.

15. Method according to one of claims 1 to 10, **characterised in that** a first function $d_{n|1}$ of the functions $d_{n|i}$ from step c) in claim 1 is calculated using the unitary transformation $\boldsymbol{T_n}$ for a natural number $N_n < \boldsymbol{N_c}$ according to: $d_{n|1}(x) =$

$$\frac{1}{N_n} \Sigma^{Nc}_{i=Nc-Nn+1} |\Sigma_m \boldsymbol{S_{x,m}} T^+_{n|m,i}|^2$$ and a second function $d_{n|2}$ is equal to a constant.

16. Method according to claim 15, **characterised in that** the correction function $\tau_n\boldsymbol{(x)}$ from step d) in claim 1 is calculated with the auxiliary functions $d_{n|1}$, $d_{n|2}$ from claim 15 according to: $\tau_n(x) = \Sigma^2_{v=1}\alpha_v d_{n|v}(x)$

17. Method according to claim 16, **characterised in that** the functional to be maximised from step e) in claim 1 comprises at least the term $\Sigma^2_{v=1}\boldsymbol{X_{n|1,v}}\alpha_v$ and as secondary conditions, which are each multiplied with a Lagrange multiplier, the terms $\Sigma^2_{v=1}\boldsymbol{X_{n|2,v}}\alpha_v$ and $\Sigma^2_{v,\mu=1}\alpha_\mu X_{n|\mu,v}\alpha_v$ with $$\boldsymbol{X_{n|i,j} = \int_w dw \underline{1} d_{n|i}(x) p_{n-1}(x) d_{n|j}(x)}$$ with the auxiliary functions $d_{n|1}$, $d_{n|2}$ from claim 15.

18. Method according to claim 16, **characterised in that** the functional to be maximised from step e) in claim 1 comprises at least the term $\Sigma^3_{v=1}\boldsymbol{X_{n|1,v}}\alpha_v$ and the term $\frac{\lambda_{Su}}{\lambda_{So}} \Sigma^3_{v=1}\boldsymbol{X_{n|2,v}}\alpha_v$ and as secondary conditions, which are each multiplied with a Lagrange multiplier, the terms $\Sigma^3_{v=1}\boldsymbol{X_{n|3,v}}\alpha_v$ and $\Sigma^3_{v,\mu=1}\alpha_\mu X_{n|v,\mu}\alpha_v$, in which $\lambda_{Su}$ is the sum of the smallest intrinsic values for the operator $[S^+S]$ determined by the relevant density divided by its number and $\lambda_{So}$ is the sum of its largest intrinsic value divided by its number and $\boldsymbol{X_{n|i,j}}$ are as defined in claim 13.

19. Method according to one of the previous claims, **characterised in that** a current density is used as the measurement variable and the magnetic field produced by this current density outside a sample is used as the auxiliary variable and/or a fuel cell is selected as the sample.

20. Method according to one of the previous claims, **characterised in that** when establishing the distribution of the measurement variable no values for the auxiliary variable are considered, which were measured at places, for which the density distribution determined by the method falls below a preset threshold value.

21. Method according to one of the previous claims, **characterised in that** the places, where the values for the auxiliary variable are measured, are on a cuboid area, particularly a cubic area, or on an elliptical area, particularly a spherical area, around the sample.

22. Device for carrying out the method according to one of the previous claims, comprising at least one measuring device for the auxiliary variable and an evaluation unit for reconstructing the distribution of the measurement variable from the measured values for the auxiliary variable, **characterised by** an evaluation unit, made for carrying out the method according to one of the previous claims, which may use the density distribution determined by the method on location coordinates.

23. Device for carrying out the method according to one of claims 1-21, comprising at least one measuring device for the auxiliary variable and an evaluation unit for reconstructing the distribution of the measurement variables from the measured values for the auxiliary variable, **characterised by** an evaluation unit, made for carrying out the method according to one of claims 1-21, which contains a list of location coordinates, where the values for the auxiliary variables are determined when carrying out the method, in which this list may contain in particular values for the density distribution determined by the method in addition to the location coordinates.

24. Device for carrying out the method according to one of claims 22 to 23, **characterised in that** for all location coordinates on the list the values for the density distribution determined by the method are at least 1.5 times, preferably at least twice as big as

- the values for this density distribution at any other place, where this density distribution is stated and/or

• the average value for this density distribution over all places, where it is stated.

**Revendications**

1. Procédé servant à optimiser une densité $\rho(x)$ de la répartition des points de mesure de détecteurs afin de mesurer les valeurs d'une grandeur auxiliaire, à partir desquelles les valeurs d'une grandeur de mesure sont définies dans un échantillon, dans lequel le lien entre la répartition de la grandeur de mesure dans l'échantillon et la grandeur auxiliaire est linéarisé d'un point de fonctionnement dans l'espace des répartitions possibles de la grandeur de mesure de sorte que les valeurs de la grandeur auxiliaire soient liées de manière linéaire aux valeurs de la grandeur de mesure de telle manière que les valeurs de la grandeur auxiliaire résultent d'une multiplication d'un opérateur S linéaire dans une représentation matricielle avec les valeurs de la grandeur de mesure, dans lequel $N_c$ valeurs de la grandeur de mesure peuvent être considérées comme une variable indépendante et le rang de la matrice par rapport à l'opérateur S linéaire est égal à la valeur $N_c$ et dans lequel au moins une première condition secondaire est fixée sous la forme d'une standardisation de la densité de la répartition, **caractérisé par** une répartition fixée sur la base d'informations a priori des points de mesure comme valeur de départ pour un procédé mis en oeuvre de manière itérative, et en ce que la densité des points de mesure est optimisée dans ledit procédé d'itération, dans lequel la modification de la densité des points de mesure $\rho_n(x)$ est définie lors de l'étape d'itération n à partir de la densité des points de mesure $\rho_{n-1}(x)$ issue de l'étape d'itération n-1 par les étapes suivantes consistant à :

   a) calculer les éléments d'un opérateur sous forme de matrice $[S^+S]_{n-1}$, qui comprend au moins l'intégration sur une zone W, à l'intérieur de laquelle des mesures ont lieu, sur le produit de la densité de la répartition des points de mesure $\rho_{n-1}(x)$ issue de l'étape d'itération n-1 avec l'opérateur S et l'opérateur $S^+$ associé audit opérateur S au niveau desdits points de mesure
   b) définir une transformation unitaire $T_n$, qui diagonalise l'opérateur $[S^+S]_{n-1}$ défini à l'étape a)
   c) définir des fonctions $d_{n|1}$, qui comprennent respectivement le montant absolu au carré de la somme d'une colonne i du produit de l'opérateur S linéaire dans la représentation matricielle avec la matrice associée par rapport à la transformation unitaire $T_n$
   d) développer une fonction de correction $\tau_n(x)$ selon les fonctions $d_{n|i}$, dans lequel ledit développement comprend une somme des fonctions $d_{n|i}$, respectivement multipliées par des coefficients de développement $\alpha_i$ restant à définir
   e) créer une fonctionnelle, qui comprend au moins un terme pour la modification de la plus petite valeur propre de l'opérateur $[S^+S]_{n-1}$, ainsi que, comme conditions secondaires qui sont multipliées respectivement par un paramètre de Lagrange, au moins deux termes, qui comprend un premier terme servant à standardiser la fonction de correction $\tau_n(x)$ selon $\int_W \rho_{n-1}(\boldsymbol{x})\tau_n^2(\boldsymbol{x})dw/W = 1$ un deuxième terme, qui comprend la deuxième condition secondaire sous la forme de la condition d'orthogonalité $\int_W \rho_{n-1}(\boldsymbol{x})\tau_n(\boldsymbol{x})dw/W = 0$, dans lequel les paramètres de Lagrange doivent être choisis de telle sorte que les conditions secondaires sont remplies, et dans lequel le développement évoqué à l'étape d) de la fonction de correction $\tau_n(x)$ est utilisé afin de créer les termes
   f) définir les valeurs des coefficients $\alpha_i$, pour lesquelles ladite fonctionnelle adopte sa valeur maximale
   g) calculer la nouvelle densité $\rho_n(x)$ de la répartition des points de mesure comme une somme, qui comprend au moins deux éléments de somme, dans lequel le premier élément de somme comprend la densité $\rho_{n-1}(x)$ issue de l'étape d'itération précédente et le deuxième élément de somme comprend le produit issu de la fonction de correction $\tau_n(x)$ par la densité $\rho_{n-1}(x)$ et par un paramètre $\varepsilon$ non négatif, dont la valeur est inférieure à la valeur positive maximale $\varepsilon_{max} = \max_\varepsilon(1 - \varepsilon\tau_n(x) \geq 0 \ \Box \ x)$ et la densité $\rho_n(x)$ définie par les étapes a) - g) est utilisée en tant que répartition initiale pour la prochaine étape d'itération selon les points a) - g) et les étapes d'itération sont répétées jusqu'à ce que la fonctionnelle optimale de l'étape e) n'autorise aucune valeur positive pour la modification de la plus petite valeur propre de l'opérateur $[S^+S]_n$.

2. Procédé selon la revendication 1, **caractérisé en ce que** toutes les valeurs de la densité $\rho_n(x)$ issues de l'étape g), qui sont inférieures à une valeur de seuil, sont rejetées et la densité $\rho_R(x)$ réduite ainsi obtenue est ensuite standardisée selon la première condition secondaire et soumise à nouveau au procédé d'itération.

3. Procédé selon l'une quelconque des revendications précédentes, **caractérisé en ce qu'**est choisie une densité, dont la valeur dépasse une valeur de seuil prédéfinie sur au total au maximum trois quarts de tous les points dans une distance finale quelconque par rapport au point central de l'échantillon, sur lequel elle est expliquée.

4. Procédé selon l'une quelconque des revendications précédentes, **caractérisé en ce qu'**est choisie une densité, dont la valeur dépasse une valeur de seuil prédéfinie sur la moitié ou au maximum sur un quart de tous les points dans une distance finale quelconque par rapport au point central de l'échantillon, sur lequel elle est expliquée.

5. Procédé selon l'une quelconque des revendications précédentes, **caractérisé en ce que** la valeur moyenne de la densité $\rho_n(x)$ sur tous les points dans la distance finale par rapport au point central de l'échantillon est choisie en tant que valeur de seuil.

6. Procédé selon l'une quelconque des revendications précédentes, **caractérisé en ce que** la valeur extrême de la fonctionnelle est définie sous la condition secondaire, qu'une convolution de la répartition des emplacements de mesure adopte une valeur prédéfinie avec une fonction de poids dépendant de l'emplacement.

7. Procédé selon l'une quelconque des revendications précédentes, **caractérisé en ce que** la valeur extrême de la fonctionnelle est définie sous la condition secondaire, qu'une convolution de la répartition des emplacements de mesure adopte avec elle-même une valeur prédéfinie.

8. Procédé selon l'une quelconque des revendications précédentes, **caractérisé en ce que** la densité est standardisée sur un en tant que première condition secondaire : $\int_W dw \frac{1}{W} \rho(x) = 1$ .

9. Procédé selon l'une quelconque des revendications précédentes, **caractérisé en ce qu'**une répartition homogène est choisie en tant que valeur de départ pour le procédé itératif.

10. Procédé selon l'une quelconque des revendications précédentes, **caractérisé en ce que** les entrées dans la ligne i et la colonne j de l'opérateur [S⁺S] par rapport à une densité $\rho(x)$ sont respectivement calculées selon :

$$[S^+S]_{i,j} = \int_W dw \frac{1}{W} \rho(x) S^+_{i,x} S_{x,j}$$ dans lequel chaque ligne correspond à l'un des points de mesure dans la matrice $S_{x,j}$.

11. Procédé selon l'une quelconque des revendications précédentes, **caractérisé en ce que** les fonctions $d_{n|i}$ issues de l'étape c) de la revendication 1 sont calculées à l'aide de la transformation unitaire $T_n$ selon :

$$d_{n|i} = |\sum_m S_{x,m} T^+_{n|m,i}|^2$$ .

12. Procédé selon l'une quelconque des revendications précédentes, **caractérisé en ce que** la fonction de correction

$\tau_n(x)$ issue de l'étape d) de la revendication 1 est calculée selon : $\tau_n(x) = \sum_{i=0}^{N_c+1} \alpha_i d_{n|i}$ en particulier sous la condition secondaire que la fonction évoquée dans la revendication 11 $d_{n|i}$ adopte par rapport à l'index i = $N_c$ + 1 une valeur constante.

13. Procédé selon l'une quelconque des revendications précédentes, **caractérisé en ce que** la fonctionnelle à maximiser issue de l'étape e) de la revendication 1 comprend au moins le terme $\sum_{v=0}^{N_c+1} X_{n|N_c,v} \alpha_v$ et, en tant que conditions secondaires, qui sont respectivement multipliées à un paramètre de Lagrande, les termes

$$\sum_{v=0}^{N_c+1} X_{n|N_c+1,v} \alpha_v \text{ et } \sum_{v,\mu=0}^{N_c+1} \alpha_\mu X_{n|\mu,v} \alpha_v$$ avec

$$X_{n|i,j} = \int_W dw \frac{1}{W} d_{n|i}(x) \rho_{n-1}(x) d_{n|j}(x)$$ .

14. Procédé selon la revendication 13, **caractérisé en ce que** la fonctionnelle à maximiser issue de l'étape e) de la revendication 1 comprend en supplément le terme $\frac{K_{n-1|N_c}}{K_{n-1|0}} \sum_{v=0}^{N_c+1} X_{n|0,v} \alpha_v$ dans lequel $K_{n-1|N_c}$ désigne la plus petite valeur propre et $K_{n-1|0}$ désigne la plus grande valeur propre de l'opérateur $[S^+S]_{n-1}$.

**15.** Procédé selon l'une quelconque des revendications 1 à 10, **caractérisé en ce qu'**une première fonction $d_{n|1}$ des fonctions $d_{n|i}$ issues de l'étape c) de la revendication 1 est calculée à l'aide de la transformation unitaire $T_n$ pour un nombre naturel $N_\eta < N_c$ selon : $d_{n|1}(x) = \frac{1}{N_\eta} \sum_{i=N_c-N_\eta+1}^{N_c} |\sum_m S_{x,m} T_{n|m,i}^+|^2$ et une deuxième fonction $d_{n|2}$ est égale à une constante.

**16.** Procédé selon la revendication 15, **caractérisé en ce que** la fonction de correction $\tau_n(x)$ issue de l'étape d) de la revendication 1 est calculée avec les fonctions auxiliaires $d_{n|1}$, $d_{n|2}$ issues de la revendication 15 selon :

$$\tau_n(x) = \sum_{v=1}^{2} \alpha_v d_{n|v}(x)$$

.

**17.** Procédé selon la revendication 16, **caractérisé en ce que** la fonctionnelle à maximiser issue de l'étape e) de la revendication 1 comprend au moins le terme $\sum_{v=1}^{2} X_{n|1,v} \alpha_v$, et, en tant que conditions secondaires, qui sont respectivement multipliées à un paramètre de Lagrande, les termes $\sum_{v=1}^{2} X_{n|2,v} \alpha_v$ et $\sum_{v,\mu=1}^{2} \alpha_\mu X_{n|\mu,v} \alpha_v$, avec $X_{n|i,j} = \int_W dw \frac{1}{W} d_{n|i}(x) \rho_{n-1}(x) d_{n|j}(x)$ avec les fonctions auxiliaires $d_{n|1}$, $d_{n|2}$ issues de la revendication 15.

**18.** Procédé selon la revendication 16, **caractérisé en ce que** la fonctionnelle à maximiser issue de l'étape e) de la revendication 1 comprend au moins le terme $\sum_{v=1}^{3} X_{n|1,v} \alpha_v$ ainsi que le terme $\frac{\lambda_{S_u}}{\lambda_{S_o}} \sum_{v=1}^{3} X_{n|2,v} \alpha_v$ et, en tant que conditions secondaires, qui sont respectivement multipliées à un paramètre de Lagrande, les termes $\sum_{v=1}^{3} X_{n|3,v} \alpha_v$ et $\sum_{v,\mu=1}^{3} \alpha_\mu X_{n|v,\mu} \alpha_v$, dans lequel $\lambda_{S_u}$ est la somme des plus petites valeurs propres de l'opérateur $[S^+S]$ défini par la densité respective divisée par leur nombre et $\lambda_{S_o}$ est la somme des plus grandes valeurs propres dudit opérateur divisée par leur nombre et les $X_{n|i,j}$ sont telles que définies dans la revendication 13.

**19.** Procédé selon l'une quelconque des revendications précédentes, **caractérisé en ce qu'**une densité de courant est utilisée en tant que grandeur de mesure et le champ magnétique produit par ladite densité de courant à l'extérieur d'un échantillon est utilisé en tant que grandeur auxiliaire et/ou une pile à combustible est choisie en tant qu'échantillon.

**20.** Procédé selon l'une quelconque des revendications précédentes, **caractérisé en ce que** n'est prise en compte, lors de la détermination de la répartition de la grandeur de mesure, aucune valeur de la grandeur auxiliaire, qui est mesurée en des emplacements, pour lesquels la répartition de densité définie par le procédé présente une valeur inférieure à une valeur de seuil prédéfinie.

**21.** Procédé selon l'une quelconque des revendications précédentes, **caractérisé en ce que** les emplacements, au niveau desquels les valeurs de la grandeur auxiliaire sont mesurées, se trouvent sur une surface carrée, en particulier sur une surface cubique, ou sur une surface elliptique, en particulier sur une surface sphérique, autour de l'échantillon.

**22.** Dispositif servant à mettre en oeuvre le procédé selon l'une quelconque des revendications précédentes, comprenant au moins un appareil de mesure pour la grandeur auxiliaire ainsi qu'une unité d'analyse servant à reconstituer la répartition de la grandeur de mesure à partir des valeurs mesurées de la grandeur auxiliaire, **caractérisé par** une unité d'analyse, réalisée aux fins de la mise en oeuvre du procédé selon l'une quelconque des revendications précédentes, laquelle est en mesure d'appliquer la répartition de densité définie par le procédé sur des coordonnées d'emplacement.

**23.** Dispositif servant à la mise en oeuvre du procédé selon l'une quelconque des revendications 1 - 21, comprenant au moins un appareil de mesure pour la grandeur auxiliaire ainsi qu'une unité d'analyse servant à reconstituer la répartition de la grandeur de mesure à partir des valeurs mesurées de la grandeur auxiliaire, **caractérisé par** une unité d'analyse, réalisée aux fins de la mise en oeuvre du procédé selon l'une quelconque des revendications 1 - 21, laquelle contient une liste de coordonnées d'emplacements, au niveau desquels les valeurs des grandeurs auxiliaires sont définies lors de la mise en oeuvre du procédé, dans lequel ladite liste peut conteneur en particulier en supplément des coordonnées d'emplacement des valeurs de la répartition de densité définie par le procédé.

**24.** Procédé servant à la mise en oeuvre du procédé selon l'une quelconque des revendications 22 à 23, **caractérisé en ce que** pour toutes les coordonnées d'emplacements de la liste, les valeurs de la répartition de densité définie par le procédé sont au moins 1,5 fois, de manière préférée 2 fois plus grandes que

- les valeurs de ladite répartition de densité au niveau de l'autre emplacement, au niveau duquel précisément ladite répartition de densité est expliquée, et/ou
- la valeur moyenne de ladite répartition de densité sur tous les emplacements, au niveau desquels elle est expliquée.

16 mm  8.4 mm  14 mm

0.6mm

178 mm

11a  12  13  11b

−  +

Figur 1

EP 2 191 444 B1

i =7

Figur 2b

i =1

Figur 2a

i =19
Figur 2d

i =14
Figur 2c

i =26

Figur 2e

i =33

Figur 2f

EP 2 191 444 B1

Figur 3a

EP 2 191 444 B1

Figur 3b

EP 2 191 444 B1

Figur 4

EP 2 191 444 B1

Figur 5

EP 2 191 444 B1

Figur 6

Figur 7a

Figur 7b

Figur 8